# EUROPEAN PATENT APPLICATION

(11) **EP 4 700 821 A1**
(43) Date of publication of application: **25.02.2026**
(21) Application number: 24792565.4
(22) Date of filing: 09.04.2024
(51) Int. Cl.: H01L 21/304, C11D 7/08, C11D 7/26, C11D 7/28, C11D 7/32, C11D 7/36, C11D 7/50

(54) **TREATMENT SOLUTION AND METHOD FOR TREATING OBJECT TO BE TREATED**

(30) Priority: 19.04.2023 JP 2023068682
(71) Applicant: FUJIFILM Corporation, Tokyo 106-8620 (JP)
(72) Inventor: MIZUTANI, Atsushi, Haibara-gun, Shizuoka 421-0396 (JP); SUGISHIMA, Yasuo, Haibara-gun, Shizuoka 421-0396 (JP); TAKAHASHI, Tomonori, Haibara-gun, Shizuoka 421-0396 (JP)
(74) Representative: HGF
(86) International application number: PCT/JP2024/014399
(87) International publication number: WO 2024/219290

(57) **Abstract**

An object of the present invention is to provide a treatment liquid for a semiconductor device, which is excellent in performance of suppressing surface roughness of a metal film containing cobalt, and a treatment method for an object to be treated, using the treatment liquid. The treatment liquid of the present invention is a treatment liquid for a semiconductor device, the treatment liquid containing water, a first component which is an alicyclic heterocyclic compound containing a nitrogen atom as a ring member atom, and a second component which is a compound different from the first component and is an alicyclic heterocyclic compound having a hydroxyl group.

## Description

### BACKGROUND OF THE INVENTION

### 1. Field of the Invention

The present invention relates to a treatment liquid and a method for treating an object to be treated.

### 2. Description of the Related Art

With the progress of miniaturization of semiconductor devices, treatment in the semiconductor device manufacturing process, such as etching and washing using a treatment liquid, is increasingly required to be more accurately performed with high efficiency.

For example, JP2017-504190A discloses a technique relating to a cleaning composition containing a redox agent, two kinds of chelating agents, a metal corrosion inhibitor, an organic solvent, water, and a desired pH adjusting agent, and discloses a method including bringing a semiconductor substrate into contact with the cleaning composition.

### SUMMARY OF THE INVENTION

As a result of studying the treatment liquid disclosed in JP2017-504190A, the present inventors have found that, in a case where the treatment liquid is applied to an object to be treated having a metal film containing cobalt, which is a wiring material, a plug material, or the like, a surface of the metal film may be roughened and fine unevenness may occur, and there is room for further improvement in this regard.

Therefore, in view of the above-described circumstances, an object of the present invention is to provide a treatment liquid for a semiconductor device, which is excellent in performance of suppressing surface roughness of a metal film containing cobalt.

Another object of the present invention is to provide a method for treating an object to be treated, using the above-described treatment liquid.

As a result of intensive studies to achieve the above-described object, the present inventors have found that the above-described object can be achieved by containing two specific components in the treatment liquid, and have completed the present invention.

That is, the above-described object can be achieved by the following configurations.
[1] A treatment liquid for a semiconductor device, the treatment liquid comprising:
   water;
   a first component which is an alicyclic heterocyclic compound containing a nitrogen atom as a ring member atom; and
   a second component which is a compound different from the first component and is an alicyclic heterocyclic compound having a hydroxyl group.
[2] The treatment liquid according to [1],
   in which the first component contains two or more nitrogen atoms as ring member atoms.
[3] The treatment liquid according to [1] or [2],
   in which the first component includes at least one selected from the group consisting of 1,8-diazabicyclo[5.4.0]undec-7-ene and 1,5-diazabicyclo[4.3.0]non-5-ene.
[4] The treatment liquid according to any one of [1] to [3],
   in which the second component contains a nitrogen atom or an oxygen atom as ring member atoms.
[5] The treatment liquid according to any one of [1] to [4],
   in which the second component is a compound represented by Formula (1) described later or a compound represented by Formula (2) described later.
[6] The treatment liquid according to any one of [1] to [5],
   in which a content of the water is 70% by mass or more with respect to a total mass of the treatment liquid.
[7] The treatment liquid according to any one of [1] to [6], further comprising:
   a chelating agent having a carboxylic acid group or a chelating agent having a phosphonic acid group.
[8] The treatment liquid according to any one of [1] to [7], further comprising:
   an organic solvent.
[9] The treatment liquid according to [8],
   in which the organic solvent includes at least one selected from the group consisting of a glycol-based solvent, a glycol ether-based solvent, an amide-based solvent, an alcohol-based solvent, and a sulfoxide-based solvent.
[10] The treatment liquid according to any one of [1] to [9], further comprising:
   a corrosion inhibitor.
[11] The treatment liquid according to [10],
   in which the corrosion inhibitor includes at least one compound selected from the group consisting of a compound represented by Formula (A) described later, a compound represented by Formula (B) described later, a compound represented by Formula (C) described later, and a substituted or unsubstituted tetrazole.
[12] The treatment liquid according to any one of [1] to [11], further comprising:
   at least one hydroxylamine compound selected from the group consisting of hydroxylamine, a derivative of hydroxylamine, and salts thereof.
[13] The treatment liquid according to any one of [1] to [12], further comprising:
   an inorganic acid.
[14] A method for treating an object to be treated, comprising:
   a step of bringing an object to be treated having a cobalt-containing layer into contact with the treatment liquid according to any one of [1] to [13].

According to the present invention, it is possible to provide a treatment liquid for a semiconductor device, which is excellent in performance of suppressing surface roughness of a metal film containing cobalt.

In addition, according to the present invention, it is possible to provide a method for treating an object to be treated, using the above-described treatment liquid.

### DESCRIPTION OF THE PREFERRED EMBODIMENTS

Hereinafter, the present invention will be described in detail.

The description of configuration requirements described below may be made based on typical embodiments of the present invention, but the present invention is not limited to such embodiments.

Any numerical range expressed using "to" in the present specification refers to a range including the numerical values before and after the "to" as a lower limit value and an upper limit value, respectively.

In the present specification, "preparation" means not only the preparation of a specific material by synthesis or mixing, but also the preparation of a predetermined substance by purchase and the like.

In the present specification, in a case where there are two or more components corresponding to a certain component, "content" of such a component means the total content of the two or more components, unless otherwise specified.

A compound described in the present specification is used to include structural isomers, optical isomers, and isotopes of the compound, unless otherwise specified. In addition, one kind of structural isomer, optical isomer, and isotope alone, or two or more kinds thereof may be included.

In the present specification, "ppm" means "parts-per-million (10⁻⁶)", "ppb" means "parts-per-billion (10⁻⁹)", and "ppt" means "parts-per-trillion (10⁻¹²)".

"Radiation" in the present specification means, for example, a bright line spectrum of a mercury lamp, far ultraviolet rays typified by an excimer laser, extreme ultraviolet rays (EUV rays), X-rays, or electron beams. In addition, in the present specification, light means the actinic ray or the radiation. Unless otherwise specified, "exposure" in the present specification includes not only exposure with a mercury lamp, far ultraviolet rays represented by an excimer laser, X-rays, or EUV rays, but also the exposure includes drawing with particle beams such as electron beams and ion beams.

### [Treatment liquid] (description based on claim 1)

The treatment liquid according to the embodiment of the present invention (hereinafter, also referred to as "present treatment liquid") is a treatment liquid for a semiconductor device, the treatment liquid containing water, a first component which is an alicyclic heterocyclic compound containing a nitrogen atom as a ring member atom, and a second component which is an alicyclic heterocyclic compound having a hydroxyl group, different from the first component.

The present treatment liquid contains the first component and the second component, each of which is an alicyclic heterocyclic compound having a predetermined structure. In a case where a treatment liquid used for treatment of a metal film containing cobalt (hereinafter, also referred to as "Co-containing film") contains the first component and the second component, an effect of suppressing occurrence of surface roughness of the Co-containing film after the treatment (hereinafter, also referred to as "effect of the present invention") can be obtained.

Hereinafter, each component contained in the treatment liquid will be described.

### [Water]

The present treatment liquid contains water.

The water is not particularly limited, and examples thereof include distilled water, ion exchange water, and pure water; and ultrapure water used for manufacturing a semiconductor device is preferable.

As the water, water in which inorganic anions, metal ions, and the like are reduced is preferable; water in which an ion concentration derived from metal atoms selected from Fe, Co, Na, K, Ca, Cu, Mg, Mn, Li, Al, Cr, Ni, and Zn is reduced is more preferable; and water adjusted to a ppb order or less (in one aspect, the metal content is less than 0.001 ppt by mass) is still more preferable in a case of being used for preparing the treatment liquid. A method of carrying out the adjustment is preferably purification using a filtration membrane or an ion-exchange membrane or purification by distillation. Examples of the method of carrying out the adjustment include a method described in paragraphs [0074] to [0084] of JP2011-110515A and a method described in JP2007-254168A.

It is preferable that the water contained in the present treatment liquid is water obtained by the above-described treatment. In addition, from the viewpoint that the effect of the present invention is remarkably obtained, it is more preferable that the above-described water is used not only for the treatment liquid but also for cleaning a storage container. In addition, the water is preferably also used in a step of producing the treatment liquid, a measurement of components of the treatment liquid, a measurement for evaluation of the treatment liquid, and the like.

A content of the water in the treatment liquid is not particularly limited, but is, for example, 50% by mass or more, preferably 60% by mass or more, more preferably 75% by mass or more, and still more preferably 85% by mass or more with respect to the total mass of the treatment liquid.

The upper limit value of the content of the water is, for example, 99.9% by mass or less, and preferably 99.0% by mass or less with respect to the total mass of the treatment liquid.

The content of the water in the treatment liquid is measured by a known measuring method such as a Karl Fischer method.

### [First component]

The present treatment liquid contains a first component which is an alicyclic heterocyclic compound containing a nitrogen atom as a ring member atom.

In the present specification, the "alicyclic heterocyclic compound" means a compound having an alicyclic heterocyclic ring (non-aromatic heterocyclic ring) and not having an aromatic ring.

The first component has an alicyclic heterocyclic ring containing at least one nitrogen atom as a ring member atom.

The first component may be ionized in the treatment liquid. In the treatment liquid, the first component may be, for example, an anion species to which a proton has been added, or an anion species from which a proton has been lost.

The alicyclic heterocyclic ring contained in the first component may be a monocyclic ring or a fused ring. In a case where the alicyclic heterocyclic ring is a fused ring, at least one of monocyclic rings constituting the fused ring contains at least one nitrogen atom as a ring member atom. In this case, at least one of the monocyclic rings constituting the fused ring may be an alicyclic hydrocarbon. In addition, the alicyclic heterocyclic ring may have an unsaturated bond or may be composed of only a saturated bond. In addition, the alicyclic heterocyclic ring may have a substituent.

The first component may have only one alicyclic heterocyclic ring or may have two or more alicyclic heterocyclic rings. In a case where the first component has two or more alicyclic heterocyclic rings, at least one alicyclic heterocyclic ring contains at least one nitrogen atom as a ring member atom. The first component preferably has only one alicyclic heterocyclic ring which is a monocyclic ring or a fused ring, and more preferably has only one alicyclic heterocyclic ring which is a fused ring.

The alicyclic heterocyclic ring may include a heteroatom other than the nitrogen atom as a ring member atom. Examples of the heteroatom include a nitrogen atom, an oxygen atom, and a sulfur atom. It is preferable that ring member atoms contained in the alicyclic heterocyclic ring of the first component are only carbon atoms and nitrogen atoms.

The number of heteroatoms (more preferably, nitrogen atoms) contained as ring member atoms in the alicyclic heterocyclic ring may be 1 or may be 2 or more, but is preferably 2 or more, more preferably 2 to 4, and still more preferably 2 or 3.

The number of ring members of the monocyclic ring constituting the alicyclic heterocyclic ring (in a case where the alicyclic heterocyclic ring is a fused ring, the number of ring members of each monocyclic ring constituting the alicyclic heterocyclic ring) is not particularly limited, but is, for example, 5 to 8, preferably 5 to 7.

Examples of the monocyclic ring containing a nitrogen atom as a ring member atom, which constitutes the alicyclic heterocyclic ring contained in the first component, include pyrrolidine, piperidine, piperazine, hexahydropyrimidine, hexahydropyridazine, 1,2,3,6-tetrahydropyrazine, 1,4,5,6-tetrahydropyrimidine, azepane, and azepine.

In a case where the alicyclic heterocyclic ring is a fused ring containing at least one alicyclic hydrocarbon, examples of the alicyclic hydrocarbon include cyclopentane, cyclohexane, and cycloheptane.

The alicyclic heterocyclic ring contained in the first component is preferably a fused ring composed of two or three of the monocyclic rings exemplified above, more preferably a fused ring composed of two of the monocyclic rings exemplified above, and still more preferably a fused ring composed of two of the monocyclic rings containing a nitrogen atom as a ring member atom exemplified above.

The alicyclic heterocyclic ring contained in the first component may have a substituent. Examples of the substituent include an aliphatic hydrocarbon group having 1 to 5 carbon atoms, an amino group, an oxo group, and a keto group. On the other hand, it is preferable that the first component does not have a hydroxyl group as the substituent of the alicyclic heterocyclic ring.

In a case where the alicyclic heterocyclic ring has a substituent, the number of substituents is not particularly limited, but is preferably 1 or 2, and more preferably 1.

The alicyclic heterocyclic ring contained in the first component preferably has no substituent or has an alkyl group having 1 to 5 carbon atoms as the substituent, and more preferably has no substituent.

Examples of the first component include 1,8-diazabicyclo[5.4.0]undec-7-ene (DBU), 1,5-diazabicyclo[4.4.0]dec-5-ene, 1,5-diazabicyclo[4.3.0]non-5-ene (DBN), 1,4-diazabicyclo[2.2.2]octane, octahydro-2H-pyrimid[1,2-a]pyrimidine, 2,5,6,7-tetrahydro-3H-pyrrolo[1.2-a]imidazole, 1,8-diazabicyclo[5.4.0]undecane, 1,5-diazabicyclo[4.4.0]decane, 1,3-diazabicyclo[3.2.2]nonane, and hexahydro-1H-1,4-diazepine.

Among these, DBU or DBN is preferable, and DBU is more preferable.

The first component may be used alone or in combination of two or more thereof.

A content of the first component is not particularly limited, but is preferably 0.01% to 10% by mass and more preferably 0.1% to 5% by mass with respect to the total mass of the treatment liquid.

### [Second component]

The present treatment liquid contains a second component which is a compound different from the first component and is an alicyclic heterocyclic compound having a hydroxyl group.

The second component may be ionized in the treatment liquid. In the treatment liquid, the second component may be, for example, an anion species to which a proton has been added, or an anion species from which a proton has been lost.

The alicyclic heterocyclic ring contained in the second component may be a monocyclic ring or a fused ring. In a case where the alicyclic heterocyclic ring is a fused ring, at least one of monocyclic rings constituting the fused ring contains at least one heteroatom as a ring member atom. In this case, at least one of the monocyclic rings constituting the fused ring may be an alicyclic hydrocarbon. In addition, the alicyclic heterocyclic ring may have an unsaturated bond or may be composed of only a saturated bond.

The second component may have only one alicyclic heterocyclic ring or may have two or more alicyclic heterocyclic rings. The second component preferably has only one alicyclic heterocyclic ring which is a monocyclic ring or a fused ring, and more preferably has only one alicyclic heterocyclic ring which is a fused ring.

Examples of the heteroatom contained as a ring member atom of the alicyclic heterocyclic ring in the second component include a nitrogen atom, an oxygen atom, and a sulfur atom. It is preferable that the second component contains a nitrogen atom or an oxygen atom as a ring member atom.

The number of heteroatoms contained as ring member atoms in the alicyclic heterocyclic ring is not particularly limited, but is preferably 1 to 4, more preferably 1 to 3, and still more preferably 1 or 2.

The number of ring members of the monocyclic ring constituting the alicyclic heterocyclic ring (in a case where the alicyclic heterocyclic ring is a fused ring, the number of ring members of each monocyclic ring constituting the alicyclic heterocyclic ring) is not particularly limited, but is, for example, 5 to 8, and preferably 5 to 7, more preferably 5 or 6, and still more preferably 6.

Examples of the monocyclic ring constituting the alicyclic heterocyclic ring in the second component or constituting the alicyclic heterocyclic ring as a fused ring include rings containing a nitrogen atom as a ring member atom, such as pyrrolidine, piperidine, piperazine, hexahydropyrimidine, hexahydropyridazine, 1,2,3,6-tetrahydropyrazine, 1,4,5,6-tetrahydropyrimidine, azepane, azepine, and hexahydro-1H-1,4-diazepine; and rings containing an oxygen atom as a ring member atom, such as tetrahydrofuran, tetrahydropyran, and oxepane.

In a case where the alicyclic heterocyclic ring is a fused ring containing at least one alicyclic hydrocarbon, examples of the alicyclic hydrocarbon include cyclopentane, cyclohexane, and cycloheptane.

The second component is preferably a fused ring composed of two or three of the monocyclic rings exemplified above, more preferably a fused ring composed of two of the monocyclic rings exemplified above, and still more preferably a fused ring composed of two of the monocyclic rings having a nitrogen atom as a ring member atom exemplified above or a fused ring composed of one of the monocyclic ring having an oxygen atom as a ring member atom exemplified above and one of the alicyclic hydrocarbon exemplified above.

The alicyclic heterocyclic ring contained in the second component has a hydroxyl group as a substituent.

The number of hydroxyl groups contained in the second component is, for example, 1 to 3, preferably 1 or 2, and more preferably 1.

The above-described hydroxyl group is substituted on a ring member atom constituting the alicyclic heterocyclic ring of the second component.

The alicyclic heterocyclic ring contained in the second component may have a substituent other than the hydroxyl group. Examples of the substituent other than the hydroxyl group include an aliphatic hydrocarbon group having 1 to 5 carbon atoms, an amino group, an oxo group, and a keto group; and an amino group or an oxo group is preferable.

The number of substituents other than the hydroxyl group in the second component is, for example, 0 to 2, preferably 0 or 1, and more preferably 0. That is, it is preferable that the second component does not have a substituent other than the hydroxyl group.

Examples of the second component include a compound represented by Formula (1) and a compound represented by Formula (2).

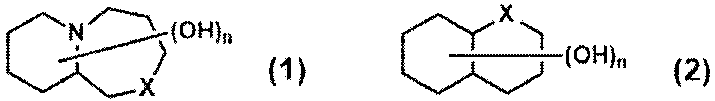

In Formula (1) and Formula (2), X's each independently represent an oxygen atom, an imino group, or an imino group having a substituent, and n represents an integer of 1 to 3.

Here, the simple notation of "imino group" represents an unsubstituted imino group (-NH-). Examples of the substituent in the imino group having a substituent, represented by X, include a hydroxyl group and the above-described substituent other than the hydroxyl group. A preferred aspect of the substituent other than a hydroxyl group, contained in the imino group, is the same as the preferred aspect of the above-described substituent other than the hydroxyl group.

X is preferably an oxygen atom or an imino group (-NH-). Among these, X in Formula (1) is more preferably an imino group, and X in Formula (2) is more preferably an oxygen atom.

n is preferably 1 or 2 and more preferably 1.

In the compound represented by Formula (1) and the compound represented by Formula (2), it is preferable that the hydroxyl group is substituted on (bonded to) a carbon atom contained in a ring containing X as a ring member atom.

The second component may be used alone or in combination of two or more thereof.

A content of the second component is not particularly limited, but is preferably 0.0001% to 5% by mass and more preferably 0.001% to 0.5% by mass with respect to the total mass of the treatment liquid.

In the treatment liquid, a ratio (mass ratio) of the content of the second component to the content of the first component (Content of second component/Content of first component) is preferably 0.01 to 1,000 and more preferably 0.1 to 50, from the viewpoint that both the suppression of the surface roughness of the Co-containing film and suppression of defects (hereinafter, also referred to as "particle defects") derived from particulate foreign matters of the treatment liquid are excellent in a well-balanced manner.

### [Optional component]

The treatment liquid may contain other optional components in addition to the above-described components. Examples of the optional component include a chelating agent, an organic solvent, a corrosion inhibitor, a hydroxylamine compound, an inorganic acid, a surfactant, and various additives.

The treatment liquid preferably contains at least one selected from the group consisting of a chelating agent, an organic solvent, a corrosion inhibitor, and a hydroxylamine compound.

Hereinafter, the optional component will be described.

### <Chelating agent>

The treatment liquid may contain a chelating agent, and from the viewpoint that the particle defect suppressiveness is more excellent, it is preferable that the treatment liquid contains a chelating agent.

The chelating agent is a compound having a function of chelating with metal ions contained in the residue. Among these, a compound which has two or more functional groups (coordinating groups) forming a coordinate bond with a metal ion in one molecule is preferable.

Examples of the coordinating group contained in the chelating agent include an acid group and a cationic group. Examples of the acid group include a carboxylic acid group, a phosphonic acid group, a phosphoric acid group, a sulfo group, and a hydroxy group; and a carboxylic acid group or a phosphonic acid group is preferable. Examples of the cationic group include an amino group.

Among these, the chelating agent is preferably a carboxylic acid-based chelating agent having at least one carboxylic acid group or a phosphonic acid-based chelating agent having at least one phosphonic acid group.

The number of carbon atoms in the chelating agent is preferably 15 or less, more preferably 12 or less, and still more preferably 9 or less. The lower limit thereof is not particularly limited, but is preferably 2 or more.

### (Carboxylic acid-based chelating agent)

Examples of the carboxylic acid-based chelating agent include a polycarboxylic acid-based chelating agent, a polyamino polycarboxylic acid-based chelating agent, and an amino acid-based chelating agent.

The polycarboxylic acid-based chelating agent is a compound having a plurality of carboxylic acid groups in one molecule. However, the polyamino polycarboxylic acid-based chelating agent and the amino acid-based chelating agent, which will be described later, are not included in the polycarboxylic acid.

Examples of the polycarboxylic acid-based chelating agent include citric acid, malonic acid, maleic acid, succinic acid, malic acid, tartaric acid, and citric acid.

The amino polycarboxylic acid-based chelating agent is a compound having at least one amino group and a plurality of carboxylic acid groups in one molecule; and examples thereof include mono- or polyalkylene polyamine polycarboxylic acid, polyaminoalkane polycarboxylic acid, polyaminoalkanol polycarboxylic acid, and hydroxyalkyl ether polyamine polycarboxylic acid.

Examples of the amino polycarboxylic acid-based chelating agent include butylenediaminetetraacetic acid, diethylenetriaminepentaacetic acid (DTPA), ethylenediaminetetrapropionic acid, triethylenetetraminehexacetic acid (TTHA), 1,3-diamino-2-hydroxypropane-N,N,N',N'-tetraacetic acid, propylenediaminetetraacetic acid, ethylenediaminetetraacetic acid (EDTA), trans-1,2-diaminocyclohexanetetraacetic acid (Cy-DTA), ethylenediaminediacetic acid (EDDA), ethylenediaminedipropionic acid, 1,6-hexamethylene-diamine-N,N,N',N'-tetraacetic acid, N,N-bis(2-hydroxybenzyl)ethylenediamine-N,N-diacetic acid, diaminopropanetetraacetic acid, 1,4,7,10-tetraazacyclododecane-tetraacetic acid, diaminopropanoltetraacetic acid, (hydroxyethyl)ethylenediaminetriacetic acid, hydroxyethyliminodiacetic acid (HIDA), iminodiacetic acid (IDA), nitrilotriacetic acid (NTA), glycol ether diaminetetraacetic acid (GEDTA), and N,N-bis(2-hydroxyethyl)glycine (DHEG).

Among these, DTPA, EDTA, HIDA, DHEG, Cy-DTA, IDA, or NTA is preferable, and DTPA, EDTA, HIDA, or DHEG is more preferable.

Examples of the amino acid-based chelating agent include glycine, serine, α-alanine (2-aminopropionic acid), β-alanine (3-aminopropionic acid), L-lysine, leucine, isoleucine, cystine, ethionine, threonine, tryptophan, tyrosine, valine, histidine, a histidine derivative, asparagine, aspartic acid, glutamine, glutamic acid, L-arginine, proline, methionine, phenylalanine, compounds described in paragraphs [0021] to [0023] of JP2016-086094A, and salts thereof.

As the histidine derivative, compounds described in JP2015-165561A, JP2015-165562A, and the like can be adopted, the contents of which are incorporated herein by reference. In addition, examples of the salt include an alkali metal salt such as a sodium salt and a potassium salt, an ammonium salt, a carbonate, and an acetate.

### (Phosphonic acid-based chelating agent)

The phosphonic acid-based chelating agent is a chelating agent having at least one phosphonic acid group in the molecule. The number of phosphonic acid groups contained in the phosphonic acid-based chelating agent is preferably 2 to 5, more preferably 2, 4, or 5, and still more preferably 2 or 5.

The phosphonic acid-based chelating agent may have a coordinating group in addition to the phosphonic acid group. In a case where the phosphonic acid-based chelating agent has an amino group as the coordinating group, the number of amino groups is preferably 1 to 4, and more preferably 2 or 3.

Examples of the phosphonic acid-based chelating agents include ethylidene diphosphonic acid, 1-hydroxyethylidene-1,1-diphosphonic acid (HEDP), 1-hydroxypropylidene-1,1-diphosphonic acid, 1-hydroxybutylidene-1,1-diphosphonic acid, ethylaminobis(methylenephosphonic acid), dodecylaminobis(methylenephosphonic acid), nitrilotris(methylenephosphonic acid) (NTMP), ethylenediaminebis(methylenephosphonic acid) (EDDP), 1,3-propylenediaminebis(methylenephosphonic acid), N,N,N',N'-ethylenediaminetetrakis(methylenephosphonic acid) (EDTMP), ethylenediaminetetra(ethylenephosphonic acid), 1,3-propylenediaminetetra(methylenephosphonic acid) (PDTMP), 1,2-diaminopropanetetra(methylenephosphonic acid), 1,6-hexamethylenediaminetetra(methylenephosphonic acid), diethylenetriaminepenta(methylenephosphonic acid) (DEPP), diethylenetriaminepenta(ethylenephosphonic acid), triethylenetetraminehexa(methylenephosphonic acid), and triethylenetetraminehexa(ethylenephosphonic acid).

In addition, as the phosphonic acid-based chelating agent, compounds described in paragraphs [0026] to [0036] of WO2018/020878A and compounds ((co)polymers) described in paragraphs [0031] to [0046] of WO2018/030006A can be used, the contents of which are incorporated herein by reference.

As the phosphonic acid-based chelating agent, HEDP, NTMP, DTMP, PDTMP, or EDDP is preferable, and HEDP, NTMP, or DTMP is more preferable.

Examples of the phosphoric acid-based chelating agent having a phosphoric acid group include condensed phosphoric acid and a salt thereof, and an organic compound having two or more phosphoric acid groups (phosphoric acid ester groups) (here, a compound functioning as a surfactant described later is excluded).

Specific examples of the phosphoric acid-based chelating agent include pyrophosphoric acid, metaphosphoric acid, tripolyphosphoric acid, tetrapolyphosphoric acid, hexametaphosphoric acid, phytic acid, and salts thereof.

Examples of the amine-based chelating agent include at least one biguanide compound selected from the group consisting of a compound having a biguanide group and a salt thereof.

The number of biguanide groups contained in the biguanide compound is not particularly limited, and a plurality of biguanide groups can be contained therein.

Examples of the biguanide compound include compounds described in paragraphs [0034] to [0055] of JP2017-504190A, the contents of which are incorporated herein by reference.

The chelating agent may be used alone or in combination of two or more thereof.

In a case where the treatment liquid contains a chelating agent, a content of the chelating agent is preferably 0.01% to 10.0% by mass, and more preferably 0.05% to 2.0% by mass with respect to the total mass of the composition, from the viewpoint that the balance between cleaning performance and anticorrosion properties is more excellent.

As the chelating agent, a chelating agent which has been subjected to a purification treatment is preferably used.

A method of purifying the chelating agent is not particularly limited, and examples thereof include known methods such as filtration, ion exchange, distillation, adsorption purification, recrystallization, reprecipitation, sublimation, and purification using a column, and combinations of these methods. Among these, a method of subjecting a raw material containing the chelating agent to a purification treatment described later to obtain a purified product containing the chelating agent is preferable.

### <Organic solvent>

The treatment liquid may contain an organic solvent, and preferably contains an organic solvent.

The organic solvent is not particularly limited, but it is preferably a hydrophilic organic solvent. In the present specification, the hydrophilic organic solvent is intended to be an organic solvent, where 0.1 g or more of the organic solvent is dissolved in 100 g of water under a condition of 25°C. As the hydrophilic organic solvent, an organic solvent which can be uniformly mixed with water at any ratio is preferable.

As the hydrophilic organic solvent, at least one selected from the group consisting of a glycol-based solvent, a glycol ether-based solvent, an amide-based solvent, an alcohol-based solvent, and a sulfoxide-based solvent is preferable.

The glycol-based solvent is not particularly limited, and examples thereof include ethylene glycol, propylene glycol, diethylene glycol, dipropylene glycol, triethylene glycol, and tetraethylene glycol.

The glycol ether-based solvent is not particularly limited, and examples thereof include a glycol monoether.

Examples of the glycol monoether include ethylene glycol monomethyl ether, ethylene glycol monoethyl ether, ethylene glycol mono-n-propyl ether, ethylene glycol monoisopropyl ether, ethylene glycol mono-n-butyl ether, diethylene glycol monomethyl ether, diethylene glycol monoethyl ether, diethylene glycol monobutyl ether, triethylene glycol monomethyl ether, triethylene glycol monoethyl ether, triethylene glycol monobutyl ether, 1-methoxy-2-propanol, 2-methoxy-1-propanol, 1-ethoxy-2-propanol, 2-ethoxy-1-propanol, propylene glycol mono-n-propyl ether, dipropylene glycol monomethyl ether, dipropylene glycol monoethyl ether, dipropylene glycol mono-n-propyl ether, tripropylene glycol monoethyl ether, tripropylene glycol monomethyl ether, ethylene glycol monobenzyl ether, and diethylene glycol monobenzyl ether.

The amide-based solvent is not particularly limited, and examples of the amide-based solvent include N,N-dimethylformamide, 1-methyl-2-pyrrolidone, 2-pyrrolidinone, 1,3-dimethyl-2-imidazolidinone, 2-pyrrolidinone, formamide, N-methylformamide, acetamide, N-methylacetamide, N,N-dimethylacetamide, N-methylpropanamide, and hexamethylphosphoric triamide.

The alcohol-based solvent is not particularly limited, and examples thereof include an alkanediol, an alkoxy alcohol, a saturated aliphatic monohydric alcohol, and an unsaturated non-aromatic monohydric alcohol.

Examples of the alkanediol include glycol, 2-methyl-1,3-propanediol, 1,3-propanediol, 2,2-dimethyl-1,3-propanediol, 1,4-butanediol, 1,3-butanediol, 1,2-butanediol, 2,3-butanediol, and pinacol.

Examples of the alkoxy alcohol include 3-methoxy-3-methyl-1-butanol, 3-methoxy-1-butanol, 1-methoxy-2-butanol, and the glycol monoether.

Examples of the saturated aliphatic monohydric alcohol include methanol, ethanol, n-propyl alcohol, isopropanol (isopropyl alcohol), 1-butanol, 2-butanol, isobutyl alcohol, tert-butyl alcohol, 2-pentanol, tert-pentyl alcohol, and 1-hexanol.

Examples of the unsaturated non-aromatic monohydric alcohol include allyl alcohol, propargyl alcohol, 2-butenyl alcohol, 3-butenyl alcohol, and 4-penten-2-ol.

Examples of the low-molecular-weight alcohol including a ring structure include tetrahydrofurfuryl alcohol, furfuryl alcohol, and 1,3-cyclopentanediol.

Examples of the sulfoxide-based solvent include dimethyl sulfoxide.

As the hydrophilic organic solvent, a glycol ether-based solvent is preferable from the viewpoint that the effect of the present invention is more excellent.

The organic solvent may be used alone or in combination of two or more thereof.

In a case where the treatment liquid contains an organic solvent, a content of the organic solvent is preferably 50% by mass or less, more preferably 20% by mass or less, and still more preferably 10% by mass or less with respect to the total mass of the treatment liquid, from the viewpoint that the effect of the present invention is more excellent. The lower limit value thereof is not particularly limited, but is preferably 0.1% by mass or more and more preferably 1.0% by mass or more with respect to the total mass of the treatment liquid.

### <Corrosion inhibitor>

The treatment liquid may contain a corrosion inhibitor, and preferably contains a corrosion inhibitor.

The corrosion inhibitor has a function of preventing corrosion of a metal layer due to over-etching or the like, by coordinating on a surface of the metal layer (particularly, the Co-containing layer) which serves as a wiring line or the like of a semiconductor device to form a film.

In the present specification, the above-described chelating agent (compound having chelating ability) is not included in the corrosion inhibitor.

Examples of the corrosion inhibitor include a compound represented by Formula (A) described later, a compound represented by Formula (B) described later, a compound represented by Formula (C) described later, and a substituted or unsubstituted tetrazole.

More specific examples of the corrosion inhibitor include 1H-1,2,4-triazole (124TZ), 5-aminotetrazole (ATA), 5-amino-1,3,4-thiadiazole-2-thiol, 3-amino-1H-1,2,4-triazole, 3,5-diamino-1,2,4-triazole, tolyltriazole, 3-amino-5-mercapto-1,2,4-triazole, 1-amino-1,2,4-triazole, 1-amino-1,2,3-triazole, 1-amino-5-methyl-1,2,3-triazole, 3-mercapto-1,2,4-triazole, 3-isopropyl-1,2,4-triazole, naphthotriazole, 1H-tetrazole-5-acetic acid, 2-mercaptobenzothiazole (2-MBT), 1-phenyl-2-tetrazoline-5-thione, 2-mercaptobenzimidazole (2-MBI), 4-methyl-2-phenylimidazole, 2-mercaptothiazoline, 2,4-diamino-6-methyl-1,3,5-triazine, thiazole, imidazole, benzimidazole, triazine, methyl tetrazole, bismuthiol I, 1,3-dimethyl-2-imidazolidinone, 1,5-pentamethylene tetrazole, 1-phenyl-5-mercaptotetrazole, diaminomethyltriazine, imidazolinethion, 4-methyl-4H-1,2,4-triazole-3-thiol, 5-amino-1,3,4-thiadiazole-2-thiol, benzothiazole, tritolyl phosphate, indazole, adenine, cytosine, guanine, thymine, phosphate inhibitors, pyrazoles, propanethiol, silanes, benzohydroxamic acids, heterocyclic nitrogen inhibitors, thiourea, 1,1,3,3-tetramethylurea, urea, urea derivatives, uric acid, potassium ethylxanthate, dodecyl phosphate, iminodiacetic acid, boric acid, nitrilotriacetic acid, sulfolane, 2,3,5-trimethylpyrazine, 2-ethyl-3,5-dimethylpyrazine, quinoxaline, acetylpyrrole, pyridazine, hystazin, pyrazine, glutathione (reduced), cystine, thiophene, mercaptopyridine N-oxide, thiamine HCl, tetraethylthiuram disulfide, 2,5-dimercapto-1,3-thiadiazole, catechol, t-butylcatechol, phenol, and pyrogallol.

Examples of the corrosion inhibitor include a substituted or unsubstituted benzotriazole (hereinafter, also referred to as "benzotriazole compound"). The substituted benzotriazole is preferably a benzotriazole substituted with an alkyl group, an aryl group, a halogen group, an amino group, a nitro group, an alkoxy group, or a hydroxyl group. The substituted benzotriazole also includes a compound in which one or more aryl groups (for example, phenyl group) or heteroaryl groups are fused.

Examples of the benzotriazole compound suitable as the corrosion inhibitor include benzotriazole (BTA), 5-aminotetrazole, 1-hydroxybenzotriazole, 5-phenylthiol-benzotriazole, 5-chlorobenzotriazole, 4-chlorobenzotriazole, 5-bromobenzotriazole, 4-bromobenzotriazole, 5-fluorobenzotriazole, 4-fluorobenzotriazole, naphthotriazole, tolyltriazole, 5-phenyl-benzotriazole, 5-nitrobenzotriazole, 4-nitrobenzotriazole, 3-amino-5-mercapto-1,2,4-triazole, 2-(5-amino-pentyl)-benzotriazole, 1-amino-benzotriazole, 5-methyl-1H-benzotriazole (5MBTA), benzotriazole-5-carboxylic acid, 4-methylbenzotriazole, 4-ethylbenzotriazole, 5-ethylbenzotriazole, 4-propylbenzotriazole, 5-propylbenzotriazole, 4-isopropylbenzotriazole, 5-isopropylbenzotriazole, 4-n-butylbenzotriazole, 5-n-butylbenzotriazole, 4-isobutylbenzotriazole, 5-isobutylbenzotriazole, 4-pentylbenzotriazole, 5-pentylbenzotriazole, 4-hexylbenzotriazole, 5-hexylbenzotriazole, 5-methoxybenzotriazole, 5-hydroxybenzotriazole, dihydroxypropylbenzotriazole, 1-[N,N-bis(2-ethylhexyl)aminomethyl]-benzotriazole, 5-t-butylbenzotriazole, 5-(1',1'-dimethylpropyl)-benzotriazole, 5-(1',1',3'-trimethylbutyl)benzotriazole, 5-n-octylbenzotriazole, and 5-(1',1',3',3'-tetramethylbutyl)benzotriazole.

In addition, examples of the benzotriazole compound include 2,2'-{[(4-methyl-1H-benzotriazole-1-yl)methyl]imino}bisethanol, 2,2'-{[(5-methyl-1H-benzotriazole-1-yl)methyl]imino}bisethanol, 2,2'-{[(4-methyl-1H-benzotriazole-1-yl)methyl]imino}bisethane, 2,2'-{[(4-methyl-1H-benzotriazole-1-yl)methyl]imino}bispropane, and N,N-bis(2-ethylhexyl)-(4 or 5)-methyl-1H-benzotriazole-1-methylamine.

From the viewpoint that the effect of the present invention is more excellent, it is preferable that the treatment liquid contains at least one compound selected from the group consisting of a compound represented by Formula (A), a compound represented by Formula (B), a compound represented by Formula (C), and a substituted or unsubstituted tetrazole.

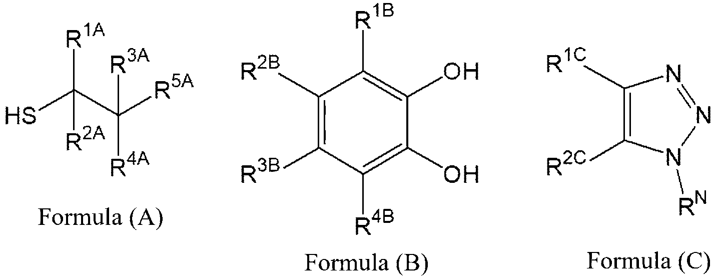

In Formula (A), R^{1A} to R^{5A} each independently represent a hydrogen atom, a substituted or unsubstituted hydrocarbon group, a hydroxyl group, a carboxy group, or a substituted or unsubstituted amino group, provided that at least one group selected from the hydroxyl group, the carboxy group, or the substituted or unsubstituted amino group is contained in a structure.

In Formula (B), R^{1B} to R^{4B} each independently represent a hydrogen atom or a substituted or unsubstituted hydrocarbon group.

In Formula (C), R^{1C}, R^{2C}, and R^{N} each independently represent a hydrogen atom or a substituted or unsubstituted hydrocarbon group, where R^{1C} and R^{2C} may be bonded to each other to form a ring.

In Formula (A), examples of the hydrocarbon represented by R^{1A} to R^{5A} include an alkyl group (preferably having 1 to 12 carbon atoms, more preferably 1 to 6 carbon atoms, and still more preferably 1 to 3 carbon atoms), an alkenyl group (preferably having 2 to 12 carbon atoms and more preferably 2 to 6 carbon atoms), an alkynyl group (preferably having 2 to 12 carbon atoms and more preferably 2 to 6 carbon atoms), an aryl group (preferably having 6 to 22 carbon atoms, more preferably 6 to 14, and still more preferably 6 to 10 carbon atoms), and an aralkyl group (preferably having 7 to 23 carbon atoms, more preferably 7 to 15 carbon atoms, and still more preferably 7 to 11 carbon atoms).

In addition, examples of the substituent in a case where the hydrocarbon group is substituted include a hydroxyl group, a carboxy group, and a substituted or unsubstituted amino group (as a substituent in a case where the amino group is substituted, an alkyl group having 1 to 6 carbon atoms is preferable and an alkyl group having 1 to 3 carbon atoms is more preferable).

In addition, in Formula (A), at least one selected from a hydroxyl group, a carboxy group, or a substituted or unsubstituted amino group (as a substituent in a case where the amino group is substituted, an alkyl group having 1 to 6 carbon atoms is preferable and an alkyl group having 1 to 3 carbon atoms is more preferable) is contained in the structure.

In Formula (A), examples of the substituted or unsubstituted hydrocarbon group represented by R^{1A} to R^{5A} include a hydrocarbon group having 1 to 6 carbon atoms, which is substituted with a hydroxyl group, a carboxy group, or an amino group.

Examples of the compound represented by Formula (A) include 1-thioglycerol, L-cysteine, and thiomalic acid.

In Formula (B), the substituted or unsubstituted hydrocarbon group represented by R^{1B} to R^{4B} has the same meaning as the substituted or unsubstituted hydrocarbon group represented by R^{1A} to R^{5A} in Formula (A) described above.

Examples of the substituted or unsubstituted hydrocarbon group represented by R^{1B} to R^{4B} include a hydrocarbon group having 1 to 6 carbon atoms, such as a methyl group, an ethyl group, a propyl group, and a t-butyl group.

Examples of the compound represented by Formula (B) include catechol and t-butylcatechol.

In Formula (C), the substituted or unsubstituted hydrocarbon group represented by R^{1C}, R^{2C}, and R^{N} has the same meaning as the substituted or unsubstituted hydrocarbon group represented by R^{1A} to R^{5A} in Formula (A) described above.

Examples of the substituted or unsubstituted hydrocarbon group represented by R^{1C}, R^{2C}, and R^{N} include a hydrocarbon group having 1 to 6 carbon atoms, such as a methyl group, an ethyl group, a propyl group, and a butyl group.

In addition, R^{1C} and R^{2C} may be bonded to each other to form a ring. Examples of the ring formed by bonding R^{1C} and R^{2C} to each other include a benzene ring. In a case where R^{1C} and R^{2C} are bonded to each other to form a ring, a substituent (for example, a hydrocarbon group having 1 to 5 carbon atoms) may be further contained.

Examples of the compound represented by Formula (C) include 1H-1,2,3-triazole (123TZ), benzotriazole (BTA), 5-methyl-1H-benzotriazole (5M-BTA), tolyltriazole, 2,2'-{[(4-methyl-1H-benzotriazol-1-yl)methyl]imino}bisethanol (product name "IRGAMET 42", manufactured by BASF SE), and N,N-bis(2-ethylhexyl)-(4 or 5)-methyl-1H-benzotriazole-1-methylamine (product name "IRGAMET 39", manufactured by BASF SE); and from the viewpoint that the effect of the present invention is more excellent, 1H-1,2,3-triazole, benzotriazole, 5-methyl-1H-benzotriazole, or tolyltriazole is preferable.

Examples of the substituted or unsubstituted tetrazole include unsubstituted tetrazole and tetrazole having a hydroxyl group, a carboxyl group, or a substituted or unsubstituted amino group as a substituent. Here, the substituent in a case where the amino group is substituted is preferably an alkyl group having 1 to 6 carbon atoms and more preferably an alkyl group having 1 to 3 carbon atoms.

The corrosion inhibitor may be used alone or in combination of two or more thereof.

In a case where the treatment liquid contains a corrosion inhibitor, a content of the corrosion inhibitor is preferably 0.01% to 5% by mass, more preferably 0.05% to 3% by mass, and still more preferably 0.1% to 1% by mass with respect to the total mass of the treatment liquid.

As the corrosion inhibitor, a corrosion inhibitor of a high-purity grade is preferably used, which is more preferably used by being further purified.

A method of purifying the corrosion inhibitor is not particularly limited, but for example, a well-known method such as filtration, ion exchange, distillation, adsorption purification, recrystallization, reprecipitation, sublimation, and purification using a column is used, and this method can be also applied in combination.

### <Hydroxylamine compound>

From the viewpoint that the performance of removing residues is more excellent, the treatment liquid may contain at least one hydroxylamine compound selected from the group consisting of hydroxylamine (NH₂OH), a hydroxylamine derivative, and salts thereof, and preferably contains the hydroxylamine compound.

The hydroxylamine compound promotes decomposition and solubilization of the residue, and has an etching residue, an ashing residue, and the like.

The hydroxylamine derivative is not particularly limited, and examples thereof include O-methylhydroxylamine, O-ethylhydroxylamine, N-methylhydroxylamine, N,N-dimethylhydroxylamine, N,O-dimethylhydroxylamine, N-ethylhydroxylamine, N,N-diethylhydroxylamine, N,O-diethylhydroxylamine, O,N,N-trimethylhydroxylamine, N,N-dicarboxyethylhydroxylamine, and N,N-disulfoethylhydroxylamine.

The salts of hydroxylamine (NH₂OH) and the hydroxylamine derivative are preferably inorganic acid salts or organic acid salts of the above-described hydroxylamine (NH₂OH) and hydroxylamine derivative, more preferably salts of inorganic acids formed by bonding non-metal atoms such as Cl, S, N, and P to hydrogen atoms, and still more preferably salts of any acid of hydrochloric acid, sulfuric acid, or nitric acid.

The inorganic acid salts of the hydroxylamine (NH₂OH) and the hydroxylamine derivative are preferably hydroxylamine nitrate, hydroxylamine sulfate, hydroxylamine hydrochloride, hydroxylamine phosphate, N,N-diethylhydroxylamine sulfate, N,N-diethylhydroxylamine nitrate, or a mixture thereof.

Examples of the organic acid salts of the hydroxylamine (NH₂OH) and the hydroxylamine derivative include a hydroxylammonium citrate, a hydroxylammonium oxalate, and a hydroxylammonium fluoride.

As the hydroxylamine compound, hydroxylamine (NH₂OH) is preferable from the viewpoint of more excellent residue removability.

The hydroxylamine compound may be used alone or in combination of two or more thereof.

In a case where the treatment liquid contains a hydroxylamine compound, a content of the hydroxylamine compound is preferably 0.1% to 20% by mass, and more preferably 0.5% to 10% by mass with respect to the total mass of the treatment liquid, from the viewpoint that the performance of suppressing the particle defects is more excellent.

### <pH adjuster>

The treatment liquid may contain a pH adjuster to adjust a pH of the treatment liquid.

Examples of the pH adjuster include an acidic compound and a basic compound.

### (Acidic compound)

The treatment liquid may contain an acidic compound as the pH adjusting agent.

The acidic compound may be an inorganic acid or may be an organic acid (here, the above-described chelating agent is excluded).

It is preferable that the treatment liquid contains an inorganic acid. Examples of the inorganic acid include sulfuric acid, hydrochloric acid, nitric acid, boric acid, phosphonic acid, and phosphoric acid; and hydrochloric acid, phosphoric acid, or sulfuric acid is preferable. Examples of the organic acid include lower (1 to 4 carbon atoms) aliphatic monocarboxylic acids such as formic acid, acetic acid, propionic acid, and butyric acid. In addition, the above-described chelating agent may also serve as the acidic compound.

### (Basic compound)

The treatment liquid may contain a basic compound as the pH adjusting agent. The basic compound is intended to be a compound in which, in a case where 1 g of the compound is dissolved in 100 g of water, a pH of the solution is made to be 9 or more.

In the present specification, the compounds contained in the first component, the second component, and the amine-based chelating agent are not included in the basic compound.

Examples of the basic compound include ammonium hydroxide, a water-soluble amine, and a quaternary ammonium salt.

In the present specification, the water-soluble amine means an amine which can be dissolved in 1 L of water with an amount of 50 g or more. None of the above are included in the water-soluble amine.

Examples of the water-soluble amine include a primary amine having a primary amino group (-NH₂) in the molecule, a secondary amine having a secondary amino group (>NH) in the molecule, a tertiary amine having a tertiary amino group (>N-) in the molecule, and salts thereof. In addition, the water-soluble amine may be a compound (amino alcohol) having at least one hydroxylalkyl group in the molecule.

Examples of the quaternary ammonium salt include a quaternary ammonium hydroxide.

Examples of the quaternary ammonium hydroxide include tetramethylammonium hydroxide (TMAH), tetraethylammonium hydroxide (TEAH), tetrapropylammonium hydroxide, tetrabutylammonium hydroxide (TBAH), methyltripropylammonium hydroxide, methyltributylammonium hydroxide, ethyltrimethylammonium hydroxide, dimethyldiethylammonium hydroxide, benzyltrimethylammonium hydroxide (BzTMAH), hexadecyltrimethylammonium hydroxide, (2-hydroxyethyl)trimethylammonium hydroxide, and spiro-(1,1')-bipyrrolidinium hydroxide; and TMAH, TEAH, TBAH, or BzTMAH is preferable.

The pH adjuster may be used alone or in combination of two or more thereof.

The type and content of the pH adjuster may be appropriately adjusted by selecting the type (acidic compound or basic compound) of the pH adjuster to be used and adjusting the content such that the pH of the treatment liquid is in a preferred range described later.

In a case where the treatment liquid contains a pH adjuster, a content thereof is preferably 0.01 % to 20% by mass, and more preferably 0.01% to 10% by mass with respect to the total mass of the treatment liquid.

The treatment liquid may contain an additive other than the above-described components. Examples of the additive include a surfactant, an antifoaming agent, and a rust inhibitor.

The content of each of the components described above contained in the treatment liquid can be measured by a known method such as a gas chromatography-mass spectrometry (GC-MS) method, a liquid chromatography-mass spectrometry (LC-MS) method, and an ion-exchange chromatography (IC) method.

### [Physical properties of treatment liquid]

### <pH>

A pH of the treatment liquid is preferably 5 to 14 and more preferably 6 to 11 at 25°C. In a case where the pH of the treatment liquid is within the above-described range, both the effect of the present invention and the residue removability can be achieved at a more excellent level.

The pH of the treatment liquid is a pH value obtained by measuring a pH at 25°C using a known pH meter according to the method based on JIS Z 8802-1984.

The pH of the treatment liquid can be adjusted by using the above-described pH adjuster or using a component having a function of the pH adjuster, such as the first component and the surfactant.

### <Metal content>

In the treatment liquid, a content (measured as an ion concentration) of each metal contained in the solution as an impurity (metal element of Fe, Co, Na, Cu, Mg, Mn, Li, Al, Cr, Ni, Zn, Sn, and Ag) is preferably 5 mass ppm or less and more preferably 1 mass ppm or less. It is assumed that, in manufacturing of a cutting-edge semiconductor element, a treatment liquid having even higher purity is required, and thus the metal content thereof is more preferably a value lower than 1 mass ppm, that is, lower than a value of mass ppb order, particularly preferably 100 mass ppb or less, and most preferably less than 10 mass ppb. The lower limit thereof is preferably 0.

The type and content of the metal in the treatment liquid can be measured by inductively coupled plasma mass spectrometry (ICP-MS).

As a device for performing the ICP-MS, for example, Agilent 8900 triple quadrupole ICP-MS (for semiconductor analysis, Option #200) manufactured by Agilent Technologies, Inc., NexION 350S manufactured by PerkinElmer Inc., Agilent 8800 manufactured by Agilent Technologies, Inc., or the like can be used.

Examples of a method for reducing the metal content include performing a purifying treatment such as distillation and filtration using an ion exchange resin or a filter at a stage of raw materials used in the production of the treatment liquid or a stage after the production of the treatment liquid.

Other examples of the method for reducing the metal content include using a container with less elution of impurities, which will be described later, as a container that accommodates the raw material or the produced treatment liquid. In addition, other examples thereof include lining an interior wall of the pipe with a fluororesin to prevent the elution of metal components from a pipe or the like during the production of the treatment liquid.

### <Coarse particles>

The treatment liquid may contain coarse particles, but it is preferable that the treatment liquid does not substantially contain coarse particles. The coarse particles mean particles having a diameter of 0.2 µm or more in a case where a shape of the particles is regarded as a sphere. In addition, the fact of being substantially free of coarse particles refers to that ten or less particles of 0.2 µm or more are present in 1 mL of the treatment liquid, in a case where the treatment liquid is subjected to measurement using a commercially available measuring device in the light scattering type in-liquid particle measuring method.

The coarse particles contained in the treatment liquid correspond to, for example, particles such as rubbish, dust, organic solid, and inorganic solid, which are contained as impurities in raw materials, and particles such as rubbish, dust, organic solid, and inorganic solid, which are brought in as contaminants during the preparation of the treatment liquid, in which those particles are finally present as particles without being dissolved in the treatment liquid.

In addition, it is preferable that the treatment liquid does not substantially contain abrasive grains.

The amount of the coarse particles present in the treatment liquid can be measured in a liquid phase by using a commercially available measuring device in a light scattering type liquid particle measuring method using a laser as a light source.

Examples of a method of removing the coarse particles include a treatment such as filtering.

### [Preparation of treatment liquid]

### <Treatment liquid preparation step>

A method for preparing the treatment liquid is not particularly limited, and the treatment liquid can be prepared by a known method. The treatment liquid can be prepared, for example, by mixing the above-described components.

Examples of the order and/or timing of mixing the above-described components include a method of sequentially adding the first component, the second component, and as necessary optional components such as the chelating agent, the organic solvent, and the corrosion inhibitor to a container containing purified pure water, stirring the mixture, and adding the pH adjuster as necessary to adjust the pH of the mixed solution. In a case where the water and the components are charged into the container, the solvent and the components may be charged at once, or may be charged in a divided manner a plurality of times.

As a stirring device and a stirring method used for preparing the treatment liquid, a known device may be used as a stirrer or a disperser. Examples of the stirrer include an industrial mixer, a portable stirrer, a mechanical stirrer, and a magnetic stirrer. Examples of the disperser include an industrial disperser, a homogenizer, an ultrasonic disperser, and a beads mill.

The mixing of the components in the step of preparing the treatment liquid, a refining treatment described later, and storage of the produced treatment liquid are preferably performed at 40°C or lower, and more preferably performed at 30°C or lower. The lower limit thereof is preferably 5°C or higher and more preferably 10°C or higher. By performing the preparation of the treatment liquid, the treatment, and/or the storage of the treatment liquid in the above-described temperature ranges, the performance can be stably maintained for a long period of time.

### <Purification treatment>

It is preferable to subject any one or more of the raw materials for preparing the treatment liquid to a purification treatment in advance. Examples of the purification treatment include known methods such as distillation, ion exchange, and filtration (filtering).

Regarding a degree of purification, it is preferable to carry out the purification treatment until the purity of the raw material is 99% by mass or more, and it is more preferable to carry out the purification treatment until the purity of the stock solution is 99.9% by mass or more. The upper limit thereof is preferably 99.9999% by mass or less.

Examples of a method of the purification treatment include a method of allowing the raw material to flow through an ion exchange resin, a reverse osmosis membrane (RO membrane), or the like, distillation of the raw material, and filtering described later.

The purification treatment may be performed by combining a plurality of the above-described purification methods. For example, the raw materials are subjected to primary purification by passing through an RO membrane, and then subjected to secondary purification by passing through a purification device consisting of a cation-exchange resin, an anion-exchange resin, or a mixed-bed type ion exchange resin.

In addition, the purification treatment may be performed a plurality of times.

### (Filtering)

Examples of a filter used for the filtering include known filters for filtration. Examples thereof include filters formed of fluororesins such as polytetrafluoroethylene (PTFE) and tetrafluoroethylene perfluoroalkyl vinyl ether copolymer (PFA), polyamide-based resins such as nylon, polyolefin resins (including those with a high density and an ultra-high molecular weight) such as polyethylene and polypropylene (PP), or the like.

Among these materials, a material selected from the group consisting of polyethylene, polypropylene (including a high-density polypropylene), a fluororesin (including PTFE and PFA), and a polyamide-based resin (including nylon) is preferable; and a filter of the fluororesin is more preferable. By carrying out filtering of the raw materials using a filter formed of these materials, high-polarity foreign matters which are likely to cause defects can be more effectively removed.

A critical surface tension of the filter is preferably 70 to 95 mN/m and more preferably 75 to 85 mN/m. The value of the critical surface tension of the filter is a nominal value of a manufacturer. In a case of using a filter having a critical surface tension in the above-described range, it is possible to effectively remove high-polarity foreign matters which are likely to cause defects.

A pore diameter of the filter is preferably 2 to 20 nm and more preferably 2 to 15 nm. Within the range, it is possible to reliably remove fine foreign matters such as impurities and aggregates contained in the raw materials while suppressing clogging in filtering. With regard to the pore diameter of the filter herein, a nominal value of the filter manufacturer can be referred to.

The filtering may be carried out only once or twice or more. In a case where the filtering is carried out twice or more, the filters used may be the same or different from each other.

In addition, a temperature of the filtering is preferably room temperature (25°C) or lower, more preferably 23°C or lower, and still more preferably 20°C or lower. In addition, the lower limit thereof is preferably 0°C or higher, more preferably 5°C or higher, and still more preferably 10°C or higher. In a case of carrying out the filtering in the above-described temperature range, it is possible to reduce the amounts of particulate foreign matter and impurities dissolved in the raw material and to efficiently remove the foreign matter and impurities.

### [Treatment liquid container]

The treatment liquid may be stored in a container and kept as it is until use.

The container and the treatment liquid stored in the container are collectively referred to as a treatment liquid container. The stored treatment liquid is taken out from the treatment liquid container, and used. In addition, the treatment liquid may be transported as the treatment liquid container.

In application for a semiconductor, the container is preferably a container which has a high degree of cleanliness inside the container and in which the elution of impurities from an interior wall of an accommodating portion of the container into the each liquid is suppressed. Examples of such a container include various containers commercially available as a container for a semiconductor treatment liquid, such as "CLEAN BOTTLE" series manufactured by AICELLO CORPORATION and "PURE BOTTLE" manufactured by Kodama Plastics Co., Ltd., but the container is not limited thereto.

It is preferable that an interior wall of the container is formed of one or more kinds of resins selected from the group consisting of a polyethylene resin, a polypropylene resin, and a polyethylene-polypropylene resin, or formed of a different resin from these. It is also preferable that the interior wall of the container is formed of a metal subjected to a rustproofing treatment or a metal elution preventing treatment, such as stainless steel, Hastelloy, Inconel, and Monel.

The above-described different resin is preferably a fluororesin (perfluororesin). As described above, in a case where a container having an interior wall formed of a fluororesin is used, occurrence of problems such as elution of an ethylene or propylene oligomer can be further suppressed than in a case where a container having an interior wall formed of a polyethylene resin, a polypropylene resin, or a polyethylene-polypropylene resin is used.

Examples of the container having an interior wall formed of a fluororesin include a FluoroPure PFA composite drum manufactured by Entegris. In addition, containers described in page 4 of JP1991-502677A (JP-H3-502677A), in page 3 of WO2004/016526A, in pages 9 and 16 of WO99/046309A, or the like can also be used.

In addition, other than the above-described fluororesin, it is also preferable that quartz or a metal material finished up with electropolishing (that is, electropolished metal material) is used in the interior wall of the container.

The metal material which is used for producing the above-described electropolished metal material is preferably a metal material which includes at least one selected from the group consisting of chromium and nickel, and has a total content of chromium and nickel of more than 25% by mass with respect to the total mass of the metal material; and examples thereof include stainless steel and a nickel-chromium alloy.

The total content of chromium and nickel in the metal material is more preferably 30% by mass or more with respect to the total mass of the metal material. The upper limit thereof is preferably 90% by mass or less.

As a method for electropolishing the metal material, a known method can be used. For example, methods described in paragraphs [0011] to [0014] of JP2015-227501A, paragraphs [0036] to [0042] of JP2008-264929A, or the like can be used.

The inside of these containers is preferably cleaned before filling the treatment liquid. With regard to a liquid used for the cleaning, the amount of metal impurities in the liquid is preferably reduced. The treatment liquid may be bottled in a container such as a gallon bottle and a coated bottle after the production, and then may be transported and stored.

In order to prevent changes in the components of the treatment liquid during the storage, the inside of the container may be purged with an inert gas (such as nitrogen and argon) having a purity of 99.99995% by volume or more. In particular, a gas with a low moisture content is preferable. In addition, during the transportation and the storage, the temperature may be normal temperature or may be controlled in a range of -20°C to 20°C to prevent deterioration.

### (Clean room)

It is preferable that handlings including production of the treatment liquid, opening and cleaning of the container, and filling of the treatment liquid, treatment analysis, and measurements are all performed in a clean room.

It is preferable that the clean room meets the 14644-1 cleanroom standard. Among these, it is more preferable that the clean room satisfies any one of International Organization for Standardization (ISO) class 1, ISO class 2, ISO class 3, ISO class 4, ISO class 5, or ISO class 6; it is still more preferable that the clean room satisfies any one of ISO class 1, ISO class 2, ISO class 3, or ISO class 4; it is particularly preferable that the clean room satisfies ISO class 1 or ISO class 2; and it is most preferable that the clean room satisfies ISO class 1.

### [Applications]

Next, the applications of the present treatment liquid will be described.

The present treatment liquid is a treatment liquid for a semiconductor device. In the present specification, the "for a semiconductor device" means that it is used in a manufacturing process of a semiconductor device. The present treatment liquid can be used in any step of manufacturing a semiconductor device.

Examples of the applications of the present treatment liquid include use as a cleaning liquid (cleaning liquid for a semiconductor substrate) in cleaning of a semiconductor substrate, and use as a treatment liquid (treatment liquid for a semiconductor substrate) for removing an object on a semiconductor substrate, such as a metal-containing substance.

The above-described cleaning liquid for a semiconductor substrate is not particularly limited as long as it is a cleaning liquid used for removing residues adhering to the semiconductor substrate, such as metal impurities and fine particles; and examples thereof include a cleaning liquid for a semiconductor substrate which has been subjected to an etching treatment (post-etching residue cleaning liquid), a cleaning liquid for a semiconductor substrate which has been subjected to a chemical mechanical polishing (CMP) treatment (pCMP cleaning liquid), a cleaning liquid for a buff cleaning of a semiconductor substrate which has been subjected to a CMP treatment (cleaning liquid for buff cleaning), a cleaning liquid for a semiconductor substrate which has been subjected to a back grinding, and a cleaning liquid for a semiconductor substrate which has been subjected to soldering of an electronic component or which has been subjected to a flux treatment to form a solder bump.

Examples of the above-described treatment liquid for a semiconductor substrate include an etchant which dissolves and removes a metal-containing substance on the semiconductor substrate, a pre-wetting liquid which is applied to the substrate in order to improve coating properties of an actinic ray-sensitive or radiation-sensitive treatment liquid before a step of forming a resist film using the actinic ray-sensitive or radiation-sensitive treatment liquid, and a rinsing liquid which is used for rinsing off a substance adhering to the semiconductor substrate.

Among the above-described use applications, the present treatment liquid may be used in only one use application or two or more of use applications.

### [Treatment method of object to be treated]

The present treatment liquid is used, for example, in a method for treating an object to be treated (hereinafter, also referred to as "present treatment method"), including a step of bringing the object to be treated into contact with the present treatment liquid. Examples of the object to be treated include the above-described object for which the present treatment liquid is used. By using the present treatment liquid in the present treatment method, it is possible to clean the object to be treated (to remove residues on the object to be treated, and the like) or to remove one or more kinds of metal-containing substances contained in the object to be treated.

More specific examples thereof include a cleaning method of removing residues attached to the object to be treated (for example, a method of cleaning etching residues on a semiconductor substrate) using the present treatment liquid. In addition, examples thereof also include an etching treatment method of dissolving and removing a metal-containing substance on a semiconductor substrate using the present treatment liquid; a pre-wetting treatment method of applying the present treatment liquid onto a semiconductor substrate before a step of forming a resist film using the actinic ray-sensitive or radiation-sensitive treatment liquid; and a rinsing treatment method of rinsing a semiconductor substrate using the present treatment liquid.

The object to be treated, which is an object to be treated in the present treatment method, is not particularly limited as long as it is a member used in a manufacturing process of a semiconductor device, and examples thereof include the above-described semiconductor substrate. Among these, a semiconductor substrate having a metal layer is preferable.

Examples of the metal layer included in the object to be treated include a simple substance and an alloy of a metal.

Examples of the metal atom contained in the metal layer include cobalt (Co), ruthenium (Ru), tungsten (W), molybdenum (Mo), aluminum (Al), copper (Cu), titanium (Ti), and tantalum (Ta).

A content of the metal atom in the metal layer is preferably 30% to 100% by mass, more preferably 40 to 100 by mass, and still more preferably 50% to 100% by mass with respect to the total mass of the metal layer.

The metal layer preferably contains cobalt, ruthenium, tungsten, molybdenum, aluminum, copper, titanium, or tantalum as a main component; more preferably contains cobalt or copper as a main component; and still more preferably contains cobalt as a main component.

In the present specification, for example, "containing cobalt as a main component" means that a content of cobalt is the highest among metal atoms contained in the metal layer. Examples of the metal layer containing cobalt as a main component (hereinafter, also referred to as "cobalt-containing layer") include a simple cobalt (metal cobalt) and a cobalt alloy (alloy in which the metal atom having the highest content is cobalt).

A content of the metal atom (preferably the cobalt atom) contained in the metal layer as a main component is preferably 50% to 100% by mass, more preferably 80 to 100 by mass, and still more preferably 95% to 100% by mass with respect to the total mass of the metal layer.

A form of the metal layer in the object to be treated is not particularly limited, and examples thereof include a form in which the metal layer is disposed in a film shape (metal-containing film) and a form in which the metal layer is disposed in a wiring shape (metal-containing wiring film).

In a case where the metal layer has a film shape or a wiring shape, a thickness thereof is not particularly limited, and may be appropriately selected according to use application. The thickness of the film-like or wiring-like metal layer is preferably 500 nm or less, and more preferably 20 nm or less. The lower limit thereof is not particularly limited, but is preferably 1 nm or more.

### [Method for treating semiconductor substrate]

Hereinafter, a semiconductor substrate which is an example of the object to be treated by the present treatment method, and the present treatment method in which the present treatment liquid is applied to the semiconductor substrate will be described in more detail.

The present treatment liquid can be used in a method for treating a semiconductor substrate, which includes a step of bringing the semiconductor substrate into contact with the present treatment liquid. Among these, the present treatment liquid is preferably used in a method for treating a semiconductor substrate having the above-described metal layer.

The semiconductor substrate may have the metal layer only on one side of the main surface of the semiconductor substrate, or may have the metal layer on both sides of the main surface of the semiconductor substrate. The metal layer may be disposed on the entire main surface of the semiconductor substrate, or may be disposed on a part of the main surface of the semiconductor substrate.

The metal layer included in the semiconductor substrate is as described above. In addition, the semiconductor substrate may have two or more metal layers having different structures and/or compositions.

In addition, the "semiconductor substrate" in the present specification includes, for example, a semiconductor substrate consisting of a single layer and a semiconductor substrate consisting of multiple layers.

Examples of the semiconductor substrate include a semiconductor substrate having the above-described metal layer (preferably the cobalt-containing layer), barrier layer, and insulating layer on a surface of a wafer constituting the substrate.

The type of the semiconductor substrate is not particularly limited, and examples thereof include various substrates such as a semiconductor wafer, a glass substrate for a photo mask, a glass substrate for liquid crystal display, a glass substrate for plasma display, a substrate for field emission display (FED), a substrate for an optical disk, a substrate for a magnetic disk, and a substrate for a magneto-optical disk.

Examples of the wafer constituting the semiconductor substrate include a wafer consisting of a silicon-based material, such as a silicon (Si) wafer, a silicon carbide (SiC) wafer, and a silicon-including resin-based wafer (glass epoxy wafer), a gallium phosphide (GaP) wafer, a gallium arsenide (GaAs) wafer, and an indium phosphide (InP) wafer. Among these, a wafer consisting of a silicon-based material, such as a silicon wafer, a silicon carbide wafer, and a resin-based wafer (a glass epoxy wafer) including silicon, is preferable.

Examples of the silicon wafer include an n-type silicon wafer in which a silicon wafer is doped with a pentavalent atom (for example, phosphorus (P), arsenic (As), antimony (Sb), or the like) and a p-type silicon wafer in which a silicon wafer is doped with a trivalent atom (for example, boron (B), gallium (Ga), or the like). Examples of the silicon of the silicon wafer include amorphous silicon, single crystal silicon, polycrystalline silicon, and polysilicon.

The size, thickness, shape, layer structure, and the like of the semiconductor substrate are not particularly limited, and can be appropriately selected as desired.

The barrier layer is not particularly limited, and examples thereof include a barrier layer containing one or more materials selected from the group consisting of Ta, tantalum nitride (TaN), Ti, titanium nitride (TiN), titanium tungsten (TiW), W, and tungsten nitride (WN). Among these, Ta, TaN, Ti, or TiN is preferable.

The insulating layer is not particularly limited, and examples thereof include an insulating layer containing one or more materials selected from the group consisting of silicon nitride (SiN), silicon oxide, silicon carbide (SiC), silicon carbonitride, silicon oxycarbide (SiOC), silicon oxynitride, and tetraethoxysilane (TEOS). Among these, silicon nitride (SiN), TEOS, silicon carbide (SiC), or silicon oxycarbide (SiOC) is preferable. In addition, the insulating layer may be composed of a plurality of layers.

The semiconductor substrate may have an object to be removed by the treatment liquid on the semiconductor substrate.

In the present specification, the "on the semiconductor substrate" includes, for example, both the front and back surfaces, the side surfaces, and the inside of the groove of the semiconductor substrate. In addition, the object to be removed on the semiconductor substrate includes not only a case where the object to be removed is directly present on the surface of the semiconductor substrate, but also a case where the object to be removed is present on the semiconductor substrate through another layer.

The semiconductor substrate may have various layers and/or structures as desired, in addition to the above description. For example, the semiconductor substrate may include a metal wire, a gate electrode, a source electrode, a drain electrode, an insulating layer, a ferromagnetic layer, and/or a non-magnetic layer.

The semiconductor substrate may include an exposed integrated circuit structure, for example, an interconnect mechanism such as a metal wire and a dielectric material. Examples of the metal and the alloy which are used in the interconnect mechanism include aluminum, a copper-aluminum alloy, copper, titanium, tantalum, cobalt, silicon, titanium nitride, tantalum nitride, and tungsten. The substrate may include layers of silicon oxide, silicon nitride, silicon carbide, and/or silicon oxide dope with carbon.

A method for manufacturing the semiconductor substrate is not particularly limited. For example, a semiconductor substrate having the insulating layer, the barrier layer, and the metal layer on a substrate can be manufactured by forming the insulating layer on the substrate, forming a hole portion (or a groove portion) in the insulating layer, forming the barrier layer and the metal layer on the insulating layer in this order, and then performing a flattening treatment such as chemical mechanical polishing (CMP).

The method of forming the barrier layer and the metal layer on the insulating layer is not particularly limited, and examples thereof include a sputtering method, a physical vapor deposition (PVD) method, an atomic layer deposition (ALD) method, a chemical vapor deposition (CVD) method, and a molecular beam epitaxy (MBE) method.

In addition, the above-described method may be performed through a predetermined mask to form a patterned metal layer on the substrate.

### <Method for cleaning semiconductor substrate>

Suitable specific examples of the present treatment method include a method for cleaning a semiconductor substrate, which includes a cleaning step of bringing the semiconductor substrate into contact with the present treatment liquid to clean the semiconductor substrate.

In a manufacturing process of a semiconductor device, in a case where a metal layer and/or an insulating layer of a semiconductor substrate is etched by plasma etching using a resist pattern as a mask, residues derived from a photoresist, the metal layer, and the insulating layer are generated on the semiconductor substrate. In addition, in a case where a resist pattern which has been unnecessary is removed by plasma ashing, residues derived from the ashing photoresist are generated on the semiconductor substrate.

The cleaning method of the semiconductor substrate is a treatment of removing residues such as the above-described etching residues and ashing residues from the semiconductor substrate, and the present treatment liquid can be used as a cleaning liquid in the cleaning method of the semiconductor substrate. By using the present treatment liquid, the above-described etching residues and/or ashing residues, generated on the semiconductor substrate which has been subjected to the etching treatment, can be removed, and the surface roughness of the metal layer (particularly, the cobalt-containing layer) included in the semiconductor substrate can be suppressed.

The method of bringing the semiconductor substrate into contact with the treatment liquid is not particularly limited, and for example, a known method performed in the field of manufacturing a semiconductor element, such as an immersion method in which the semiconductor substrate is immersed in the treatment liquid, a spin (dropwise) method in which the treatment liquid is dropped while rotating the semiconductor substrate, a spraying (spray) method in which the treatment liquid is sprayed, and a scrub cleaning in which a cleaning member such as a brush is brought into physical contact with the surface of the semiconductor substrate while supplying the treatment liquid to the semiconductor substrate to remove residues and the like, is appropriately adopted.

In the cleaning of the semiconductor substrate, a mechanical stirring method may be used in order to further reduce the impurities remaining on the surface of the semiconductor substrate and further enhance the cleaning ability of the treatment liquid. Examples of the mechanical stirring method include a method of circulating the treatment liquid on the semiconductor substrate, a method of flowing or spraying the treatment liquid on the semiconductor substrate, and a method of stirring the treatment liquid with ultrasonic wave or megasonic wave.

The above-described cleaning may be carried out only once or twice or more. In a case of carrying out the cleaning two or more times, the same method may be repeated or different methods may be combined.

The cleaning method of a semiconductor substrate may be a single-wafer method or a batch method.

The single-wafer method is generally a method of treating semiconductor substrates one by one, and the batch method is generally a method of treating a plurality of semiconductor substrates at the same time.

A temperature of the treatment liquid which is used for cleaning the semiconductor substrate is not particularly limited as long as it is a temperature which is usually used in this field. The cleaning is generally carried out at room temperature (approximately 25°C), but any temperature can be selected in order to improve cleanability and suppress damage to the member. A temperature of the treatment liquid is preferably 10°C to 60°C and more preferably 15°C to 50°C.

A cleaning time in the cleaning of the semiconductor substrate can be appropriately changed depending on the type, content, and the like of the components contained in the treatment liquid. Practically, the cleaning time is preferably 10 to 120 seconds, more preferably 20 to 90 seconds, and still more preferably 30 to 60 seconds.

A supply amount (supply rate) of the treatment liquid in a case where the treatment liquid is dropped or sprayed on the semiconductor substrate is preferably 50 to 5,000 mL/min and more preferably 500 to 2,000 mL/min.

### (Rinsing step)

After the above-described cleaning step, a step of rinsing and cleaning the semiconductor substrate with a solvent (hereinafter, referred to as "rinsing step") may be performed.

The rinsing step is preferably a step which is performed continuously subsequently after the above-described cleaning step, in which the semiconductor substrate is rinsed with a rinsing liquid for 5 to 300 seconds. The rinsing step may be performed by the above-described mechanical stirring method.

Examples of the rinsing liquid include water (preferably deionized (DI) water), methanol, ethanol, isopropanol, N-methylpyrrolidinone, γ-butyrolactone, dimethyl sulfoxide, ethyl lactate, and propylene glycol monomethyl ether acetate. In addition, an aqueous rinsing liquid having a pH of more than 8.0 (aqueous ammonium hydroxide which has been diluted, or the like) may be used.

As a method of bringing the rinsing liquid into contact with the semiconductor substrate, the above-described method of bringing the treatment liquid into contact with the semiconductor substrate can be similarly adopted.

### (Drying step)

After the above-described cleaning step or rinsing step, a drying step of drying the semiconductor substrate may be performed.

Examples of the drying method include a spin drying method, a method of flowing a dry gas onto the semiconductor substrate, a method of heating the semiconductor substrate by a heating unit such as a hot plate and an infrared lamp, a Marangoni drying method, a Rotagoni drying method, an isopropanol (IPA) drying method, and any combinations thereof.

A drying time in the drying step depends on the specific method used, but is preferably 20 seconds to 5 minutes.

### <Etching treatment of semiconductor substrate>

Other specific examples of the present treatment method include an etching treatment method in which a semiconductor substrate having the metal-containing layer (particularly, a cobalt-containing layer) is brought into contact with the present treatment liquid to dissolve and remove the metal-containing layer (particularly, the cobalt-containing layer). That is, the present treatment liquid can be used as an etchant in an etching treatment for removing the metal-containing layer on the semiconductor substrate.

Examples of the etching treatment include a method of dissolving and removing metal-containing substances on the semiconductor substrate by bringing the treatment liquid into contact with the semiconductor substrate. The method of bringing the semiconductor substrate into contact with the treatment liquid is not particularly limited, and the method described in the method for cleaning a semiconductor substrate can be applied.

More specific examples of the above-described treatment method include a method for treating a semiconductor substrate, which includes a step P of subjecting a semiconductor substrate containing a metal layer to an oxidation treatment for oxidizing a surface layer of the metal layer to form a metal oxide layer, and a step Q of bringing the treatment liquid into contact with a surface of the metal oxide layer formed in the step P to dissolve the metal oxide layer.

The metal layer is the same as the above-described metal layer included in the object to be treated, including the preferred aspect.

The above-described metal oxide layer is a layer formed by oxidizing the surface layer of the above-described metal layer, and can also be said to be one form of a metal-based material. A part of the surface layer of the metal layer may be the metal oxide layer, or the entire surface layer of the metal layer may be the metal oxide layer.

The metal oxide layer is an oxide of a simple substance or an alloy of a metal, and is preferably a layer consisting of a cobalt oxide, an oxide of a cobalt alloy, a ruthenium oxide, an oxide of a ruthenium alloy, a molybdenum oxide, an oxide of a molybdenum alloy, an aluminum oxide, an oxide of an aluminum alloy, a copper oxide, or an oxide of a copper alloy; more preferably a layer consisting of a cobalt oxide or an oxide of a cobalt alloy; and still more preferably a layer consisting of a cobalt oxide.

A thickness of the metal oxide layer is, for example, equivalent to 1 to 10 atomic layers. The thickness of one atomic layer of the metal and the metal oxide is 1 nm or less (for example, 0.3 nm to 0.4 nm).

In many cases, the metal oxide layer has high solubility (is easily etched) in the treatment liquid as compared with the metal layer. That is, in the step P, the surface of the metal layer is made to be a thin metal oxide layer, and in the step Q, only the metal oxide layer (and a portion of the metal oxide layer in which the metal layer existing in the underlayer of the metal oxide layer can be inevitably dissolved) is removed using the treatment liquid, whereby only a very thin surface of the metal layer included in the semiconductor substrate can be removed (dissolved).

Furthermore, in a case of repeatedly performing the step P and the step Q alternately, it is possible to control the etching amount with high accuracy.

In a case where the step P and the step Q are alternately performed, the number of times of each step to be performed may be, for example, 1 to 20 cycles in a case where a combination of the step P and the step Q is defined as one cycle. From the viewpoint of excellent control of the recess amount, the number of times of each step to be performed in a case where the step P and the step Q are alternately performed is preferably 3 cycles or more and more preferably 5 cycles or more.

The semiconductor substrate may include one kind of the metal layer alone, or may include two or more kinds thereof. In addition, the semiconductor substrate may contain a metal-based material other than the metal layer or the metal oxide layer, and a part or all of such a metal-based material may be intentionally or inevitably removed through the step P and the step Q.

The step P is a step of subjecting the semiconductor substrate including the above-described metal layer to an oxidation treatment for oxidizing a surface layer of the above-described metal layer to form a metal oxide layer.

The method of performing an oxidation treatment for oxidizing the surface layer of the metal layer to form a metal oxide layer is not limited; and examples thereof include a liquid treatment of bringing an oxidizing liquid into contact with the semiconductor substrate, a gas treatment of bringing an oxidizing gas into contact with the semiconductor substrate (an ozone treatment of bringing an ozone gas into contact with the substrate, a heating treatment in oxygen of heating the semiconductor substrate in an oxygen atmosphere, and the like, which will be described later), and a plasma treatment using an oxygen gas.

One kind of the oxidation treatment may be performed, or two or more kinds thereof may be performed.

The above-described oxidizing liquid may be any chemical liquid as long as it can oxidize the surface layer of the above-described metal layer. The oxidizing liquid is preferably a chemical liquid other than the present treatment liquid.

The oxidizing liquid is preferably a chemical liquid (hereinafter, also referred to as "specific chemical liquid") selected from the group consisting of water, hydrogen peroxide water, a mixed aqueous solution of ammonia and hydrogen peroxide (APM), a mixed aqueous solution of hydrofluoric acid and hydrogen peroxide water (FPM), a mixed aqueous solution of sulfuric acid and hydrogen peroxide water (SPM), a mixed aqueous solution of hydrochloric acid and hydrogen peroxide water (HPM), oxygen-dissolved water, ozone-dissolved water, perchloric acid, and nitric acid.

Regarding a composition of the hydrogen peroxide water, for example, a content of H₂O₂ is 0.5% to 31% by mass, more preferably 3% to 15% by mass, with respect to the total mass of the hydrogen peroxide water.

A composition of APM is, for example, preferably within a range (mass ratio) of "ammonia water:hydrogen peroxide water:water = 1:1:1" to "ammonia water:hydrogen peroxide water:water = 1:3:45".

A composition of FPM is, for example, preferably within a range (mass ratio) of "hydrofluoric acid: hydrogen peroxide water: water = 1:1:1" to "hydrofluoric acid: hydrogen peroxide water: water = 1:1: 200".

A composition of SPM is, for example, preferably within a range (mass ratio) of "sulfuric acid:hydrogen peroxide water:water = 3:1:0" to "sulfuric acid:hydrogen peroxide water:water = 1:1:10".

A composition of HPM is, for example, preferably within a range (mass ratio) of "hydrochloric acid:hydrogen peroxide water:water = 1:1:1" to "hydrochloric acid:hydrogen peroxide water:water = 1:1:30".

These descriptions of the preferred compositional ratios are intended to be compositional ratios in a case where the ammonia water is 28% by mass ammonia water, the hydrofluoric acid is 49% by mass hydrofluoric acid, the sulfuric acid is 98% by mass sulfuric acid, the hydrochloric acid is 37% by mass hydrochloric acid, and the hydrogen peroxide water is 30% by mass hydrogen peroxide water.

In addition, the volume ratio is based on the volume at room temperature.

The description ["A:B:C = x:y:z" to "A:B:C = X:Y:Z"] as a suitable range indicates that it is preferable to satisfy at least one range of ["A:B = x:y" to "A:B = X:Y"], ["B:C = y:z" to "B:C = Y:Z"], or ["A:C = x:z" to "A:C = X:Z"] (preferably two ranges and more preferably all the ranges).

A composition of the oxygen-dissolved water is, for example, an aqueous solution in which A content of O₂ is 20 to 500 ppm by mass with respect to the total mass of the oxygen-dissolved water.

A composition of the ozone-dissolved water is, for example, an aqueous solution in which a content of O₃ is 1 to 60 ppm by mass with respect to the total mass of the ozone-dissolved water.

The perchloric acid is, for example, an aqueous solution in which a content of HClO₄ is 0.001% to 60% by mass with respect to the total mass of the solution.

The nitric acid is, for example, an aqueous solution in which a content of HNO₃ is 0.001 % to 60% by mass with respect to the total mass of the solution.

The method of bringing the semiconductor substrate into contact with the oxidizing liquid (preferably, the specific chemical liquid) is not particularly limited; and examples thereof include a method of immersing the semiconductor substrate in the oxidizing liquid charged in a tank, a method of spraying the oxidizing liquid onto the semiconductor substrate, a method of flowing the oxidizing liquid onto the semiconductor substrate, and any combination thereof.

A contact time between the semiconductor substrate and the oxidizing liquid is, for example, preferably 0.25 to 10 minutes, and more preferably 0.5 to 5 minutes.

A temperature of the oxidizing liquid is preferably 20°C to 75°C and more preferably 20°C to 60°C.

In the gas treatment, examples of the oxidizing gas which is brought into contact with the semiconductor substrate include dry air, an oxygen gas, an ozone gas, and a mixed gas thereof. The oxidizing gas may contain a gas other than the above-described gas.

In the gas treatment, the oxidizing gas brought into contact with the semiconductor substrate is preferably an oxygen gas or an ozone gas. In a case where the semiconductor substrate is brought into contact with an oxygen gas or an ozone gas, it is also preferable to bring the semiconductor substrate into contact with the oxygen gas or the ozone gas in an oxygen atmosphere, in an ozone atmosphere, or in a mixed gas atmosphere of oxygen and ozone.

In the gas treatment, an aspect in which the semiconductor substrate is heated (for example, heated at 40°C to 200°C) while being brought into contact with the oxidizing gas is also preferable.

Among these, the gas treatment is preferably an ozone treatment in which the ozone gas is brought into contact with the semiconductor substrate, or a heating treatment in oxygen, in which the semiconductor substrate is heated in an oxygen atmosphere.

In the above-described ozone treatment, the ozone gas may be brought into contact with the semiconductor substrate in an ozone atmosphere, or the ozone gas may be brought into contact with the semiconductor substrate in a mixed gas atmosphere of the ozone gas and other gases (for example, the oxygen gas). In addition, the ozone treatment may be a treatment of heating the semiconductor substrate while bringing the ozone gas into contact with the semiconductor substrate.

The step Q is a step of bringing the semiconductor substrate obtained in the above-described step P into contact with the present treatment liquid to dissolve the above-described metal oxide layer. The method of bringing the semiconductor substrate into contact with the present treatment liquid in the step Q is not particularly limited, and examples thereof include the same examples as those of the method of bringing the semiconductor substrate into contact with the oxidizing liquid.

A contact time between the semiconductor substrate and the treatment liquid is, for example, preferably 0.25 to 10 minutes, and more preferably 0.5 to 5 minutes.

A temperature of the treatment liquid is preferably 20°C to 75°C and more preferably 20°C to 60°C.

In the step Q, the removal of the metal oxide layer may be carried out partially or entirely.

In the step Q, a part or all of the metal layer (for example, a metal layer exposed on the surface layer by removing the metal oxide layer covering the surface) may be intentionally or unavoidably removed.

The treatment liquid to be subjected to the step Q may be subjected to a degassing treatment or the like in advance to reduce the amount of dissolved oxygen. In a case where the metal layer exposed by the removal of the metal oxide layer by the treatment liquid is oxidized by the dissolved oxygen in the treatment liquid to form a new metal oxide layer, and the metal oxide layer is further removed by the treatment liquid, the removal of the excessive amount of the metal layer can be suppressed by reducing the amount of dissolved oxygen in the treatment liquid.

For specific aspects of the treatment method of removing an objective substance such as a metal-containing substance on a semiconductor substrate using the present treatment liquid, the description in paragraphs [0049] to [0069] of WO2019/138814A can be referred to, the contents of which are incorporated herein by reference.

The present treatment method may be performed in combination before or after other steps performed in the manufacturing of the semiconductor device. The present treatment method may be incorporated into other steps while performing the above-described treatment, or the present treatment method may be incorporated between other steps.

Examples of the other steps include a step of forming each structure such as a metal wire, a gate structure, a source structure, a drain structure, an insulating layer, a ferromagnetic layer, and/or a non-magnetic layer (layer formation, etching, a CMP treatment, modification, or the like), a resist forming step, an exposure step and a removal step, a heat treatment step, a cleaning step, and an examination step.

The above-described treatment may be carried out at any stage of a back-end-of-the-line (BEOL) process, a middle-of-the-line (MOL) process, and a front-end-of-the-line (FEOL) process.

### Examples

Hereinbelow, the present invention will be described in more detail with reference to Examples. The materials, the amounts of materials used, the proportions, the treatment details, the treatment procedure, and the like shown in Examples below may be modified as appropriate as long as the modifications do not depart from the spirit of the present invention. Therefore, the scope of the present invention should not be construed to be limited by Examples described below.

### [Raw material]

Each treatment liquid of Examples and Comparative Example was prepared using the following components as raw materials.

Here, in the preparation of the treatment liquid, a treatment liquid classified into a semiconductor grade or a high-purity grade equivalent thereto was used.

The following shows various components used as the raw materials in the preparation of the treatment liquid.

### <First component>

· DBU: 1,8-diazabicyclo[5.4.0]undec-7-ene
· DBN: 1,5-diazabicyclo[4.3.0]non-5-ene

### <Second component>

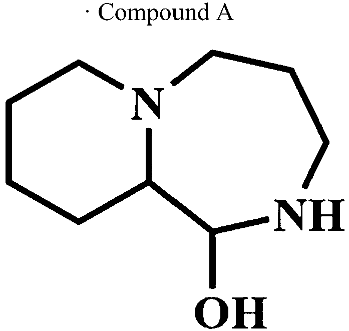

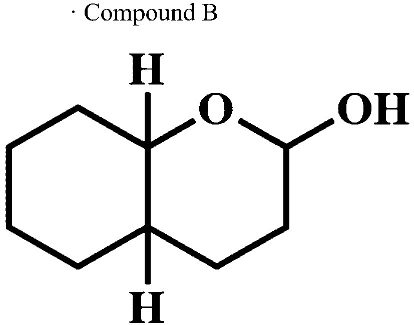

### <Hydroxylamine compound (HA compound)>

· HA: Hydroxylamine

### <Organic solvent>

· EGME: ethylene glycol monomethyl ether
· EGBE: ethylene glycol mono-n-butyl ether
· MMB: 3-methoxy-3-methyl-1-butanol
· Sulfolane
· DEGEE: diethylene glycol monoethyl ether
· PG: propylene glycol
· DEGBE: diethylene glycol monobutyl ether

### <Corrosion inhibitor>

· Tetrazole: tetrazole
· 5M-BTA: 5-methyl-1H-benzotriazole (corresponding to the compound represented by Formula (C))
· BTA: benzotriazole (corresponding to the compound represented by Formula (C))
· 123TZ: 1H-1,2,3-triazole (corresponding to the compound represented by Formula (C))
· 124TZ: 1H-1,2,4-triazole

### <Chelating agent>

· DHEG: N,N-bis(2-hydroxyethyl)glycine
· DTPA: diethylenetriaminepentaacetic acid
· EDTA: ethylenediaminetetraacetic acid
· HIDA: hydroxyethyliminodiacetic acid
· EDTMP: N,N,N',N'-ethylenediaminetetrakis(methylenephosphonic acid) · NTMP: nitrilotris(methylenephosphonic acid) (NTMP)
· HEDP: 1-hydroxyethylidene-1,1-diphosphonic acid

### <Inorganic acid>

· H₃PO₄: phosphoric acid

### <Water>

· Ultrapure water

### [Comparative Example 1]

A dehydration treatment was carried out on a substance to be purified consisting of DBU, obtained as a commercially available product, by a column method using Molecular Sieves 3A (manufactured by FUJIFILM Wako Pure Chemical Corporation). Next, the dehydrated substance to be purified was distilled and purified using a distillation column in which a first plate distillation column (theoretical number of plates: 150 plates) not equipped with a pressure reducing mechanism and a second plate distillation column (theoretical number of plates: 150 plates) equipped with a pressure reducing mechanism were connected in series, in order from the first plate distillation column.

Furthermore, the distillation-purified substance to be purified was subjected to circulation filtration purification using a filtering device including a flow path in which an ion exchange resin and a filter shown below were connected in series in order from the upstream side, and a return path for returning the substance to be purified from the most downstream side to the most upstream side of the flow path. The number of circulations was set to 50.

Hereinafter, details of each member in the filtering device are described in order from the upstream side.
· Anion exchange resin (anion exchange resin described in Production Example 1 of paragraph 0028 of JP2009-155208A)
· Ion exchange filter (manufactured by Pall Corporation, IonKleen SL)
· Nylon filter (manufactured by Pall Corporation, Asymmetric, pore diameter: 5 nm)
· UPE filter (manufactured by Entegris., Purasol SP/SN solvent purifier)
· PTFE filter (manufactured by Pall Corporation, XpressKLEEN, pore diameter: 3 nm)
· UPE filter (manufactured by Entegris., Microgard, pore diameter: 3 nm)

In such circulation filtration purification, an operation of passing the substance to be purified from the purification member on the most upstream side to the purification member on the most downstream side was counted as one circulation.

A composition of the purified product obtained by the above-described purification treatment was measured by GC-MS ("GCMS-QP2020 NX" manufactured by Shimadzu Corporation). In the GC-MS measurement, a diluted liquid obtained by diluting the first component with methanol was used as a measurement target, as necessary.

Next, the purified product containing purified DBU, ultrapure water, and a chelating agent (NTMP) were mixed so as to have the composition shown in Table 1, and then tetraethylammonium hydroxide (TEAH) was added to the mixture to adjust the pH to the numerical value shown in the column of "pH of treatment liquid" in Table 1, thereby preparing a treatment liquid of Comparative Example 1.

### [Examples 1 to 29]

A purification treatment was performed on a substance to be purified consisting of the first component (DBN or DBU) obtained as a commercial product in the same manner as in Comparative Example 1, and then a composition of the purified product after the purification treatment was measured using GC-MS ("GCMS-QP2020 NX" manufactured by Shimadzu Corporation).

Next, the purified first component, ultrapure water, and components other than the first component and water, which were added as necessary, were mixed according to the compositions of the respective treatment liquids described in Tables 1 and 2, and then hydrochloric acid or tetraethylammonium hydroxide (TEAH) was added to the mixture to adjust the pH to the numerical value described in the column of "pH of treatment liquid" of Tables 1 and 2, thereby preparing each treatment liquid of Examples.

### [Evaluation]

### <Co film roughness>

A silicon wafer (diameter: 300 mm) having a metal film consisting of cobalt (wiring model; hereinafter, also referred to as "Co film") on the surface was prepared. A thickness of the Co film was 30 nm.

A wafer with the Co film was set in a spin rotation wafer processing device (manufactured by Ekc Technology Inc.). Each treatment liquid of Examples and Comparative Example was jetted onto the surface of the set wafer at a flow rate of 1.5 L/min for 1 minute. Next, a rinsing treatment of jetting ultrapure water onto the surface of the wafer at a flow rate of 1 L/min for 30 seconds was carried out, and then the wafer was spin-dried.

A region of 5 µm square was randomly selected from the surface of the dried Co film, and a surface roughness Ra in the selected region was measured using an atomic force microscope. The surface roughness Ra of the Co film after the treatment with each treatment liquid was determined by changing the region to be selected and performing a total of three measurements and calculating an arithmetic mean of the obtained measured values.

From the obtained surface roughness Ra of the Co film, the degree of surface roughness (Co film roughness) of the Co film treated with each treatment liquid was evaluated according to the following evaluation standard. The results are shown in Tables 1 and 2.

### (Evaluation standard for Co film roughness)

"A": surface roughness Ra of the Co film was 1.0 nm or less.

"B": surface roughness Ra of the Co film was more than 1.0 nm and 2.0 nm or less.

"C": surface roughness Ra of the Co film was more than 2.0 nm and 3.0 nm or less.

"D": surface roughness Ra of the Co film was more than 3.0 nm.

### <Particle defect suppressiveness>

A silicon wafer having a diameter of 300 mm was prepared, and the number and address of particulate foreign matters having a diameter of 28 nm or more, which were present on the surface of the wafer, were measured using a defect evaluation device "UVision8" (manufactured by Applied Materials, Inc.).

The wafer in which the above-described measurement of foreign matters was carried out was set in a spin rotation wafer processing device (manufactured by Ekc Technology Inc.). Each treatment liquid of Examples and Comparative Example was jetted onto the surface of the set wafer at a flow rate of 1.5 L/min for 1 minute. Next, a rinsing treatment of jetting ultrapure water onto the surface of the wafer at a flow rate of 1 L/min for 30 seconds was carried out, and then the wafer was spin-dried.

For the obtained dried wafer, the number and address of the particulate foreign matters having a diameter of 28 nm or more, which were present on the surface of the wafer, were measured using the above-described defect evaluation device.

The number of particulate foreign matters having a diameter of 28 nm or more (hereinafter, also referred to as "number of particle defects") derived from the treatment liquid was calculated by subtracting the number of particulate foreign matters measured before the treatment from the number of particulate foreign matters measured after the treatment. Based on the obtained number of particle defects derived from the treatment liquid, particle defect suppressiveness of each treatment liquid was evaluated according to the following evaluation standard. The results are shown in Tables 1 and 2.

### (Evaluation standard for particle defect suppressiveness)

"S": number of particle defects derived from the treatment liquid was 0 or more and less than 100.

"A": number of particle defects derived from the treatment liquid was 100 or more and less than 500.

"B": number of particle defects derived from the treatment liquid was 500 or more and less than 1,000.

"C": number of particle defects derived from the treatment liquid was 1,000 or more.

Table 1 and Table 2 show the compositions of the treatment liquids prepared in each of Examples and Comparative Example, and the evaluation results thereof.

In the tables, the column of "Content [% by mass]" indicates the content (% by mass) of the corresponding component.

"A" and "B" in the column of "Second component" respectively indicate the above-described compound A and the above-described compound B.

"HA compound" indicates the hydroxylamine compound.

**[Table 1]**

| | Composition of treatment liquid | | | | | | | | | | | | | | | pH of treatment liquid | Evaluation | |
|---|---|---|---|---|---|---|---|---|---|---|---|---|---|---|---|---|---|---|
| | First component | | Second component | | HA compound | | Organic solvent | | Corrosion inhibitor | | Chelating agent | | Inorganic acid | | Water | | Co film roughness | Particle defect suppressiveness |
| | Type | Content [% by mass] | Type | Content [% by mass] | Type | Content [% by mass] | Type | Content [% by mass] | Type | Content [% by mass] | Type | Content [% by mass] | Type | Content [% by mass] | | | | |
| Example 1 | DBN | 1.0 | B | 0.005 | | | EGME | 1.0 | Tetrazole | 0.2 | DHEG | 0.1 | | | Reminder | 8.0 | A | A |
| Example 2 | DBU | 0.8 | A | 0.008 | | | EGBE | 3.0 | 5M-BTA | 0.2 | DTPA | 0.6 | | | Reminder | 8.9 | A | A |
| Example 3 | DBU | 5.0 | B | 0.1 | | | MMB | 3.0 | BTA | 0.1 | EDTA | 0.2 | | | Reminder | 9.0 | A | A |
| Example 4 | DBU | 2.2 | A | 0.4 | | | Sulfolanc | 5.0 | 123TZ | 0.1 | HIDA | 0.4 | | | Reminder | 7.0 | A | A |
| Example 5 | DBU | 0.6 | B | 3.0 | | | DMSO | 10.0 | 124TZ | 0.2 | | | | | Reminder | 10.0 | A | B |
| Example 6 | DBU | 0.8 | A | 0.2 | | | Sulfolanc | 20.0 | | | HIDA | 0.1 | | | Reminder | 11.0 | B | A |
| Example 7 | DBU | 1.0 | A | 0.4 | HA | 1.0 | DMSO | 15.0 | | | DTPA | 0.3 | | | Reminder | 9.0 | B | A |
| Example 8 | DBU | 1.3 | B | 0.01 | | | DEGEE | 8.0 | | | EDTMP | 0.1 | | | Reminder | 9.5 | B | A |
| Example 9 | DBN | 1.8 | A | 0.002 | | | DEGEE | 10.0 | 124TZ | 0.2 | | | | | Reminder | 8.5 | A | B |
| Example 10 | DBU | 0.8 | B | 0.03 | | | PG | 3.0 | | | | | | | Reminder | 8.0 | B | A |
| Example 11 | DBU | 0.2 | A | 0.005 | HA | 1.0 | DEGBE | 1.0 | | | EDTA | 0.1 | | | Reminder | 7.0 | B | A |
| Example 12 | DBN | 0.3 | B | 0.06 | | | DEGEE | 3.0 | | | DTPA | 0.1 | | | Reminder | 7.5 | B | A |
| Example 13 | DBU | 0.2 | A | 0.001 | HA | 5.0 | DEGBE | 1.0 | | | NTMP | 0.1 | | | Reminder | 9.2 | B | A |
| Example 14 | DBN | 0.3 | B | 0.001 | | | | | | | | | | | Reminder | 10.4 | B | B |
| Example 15 | DBU | 0.2 | A | 0.05 | | | EGBE | 8.0 | | | | | | | Reminder | 11.3 | B | A |
| Example 16 | DBN | 0.3 | B | 0.03 | HA | 3.0 | PG | 3.0 | 5M-BTA | 0.2 | | | | | Reminder | 9.5 | B | A |
| Example 17 | DBU | 4.0 | B | 0.1 | | | EGBE | 3.0 | 5M-BTA | 0.1 | HEDP | 0.15 | | | Reminder | 9.0 | A | A |
| Example 18 | DBU | 1.0 | A | 0.03 | | | EGBE | 5.0 | BTA | 0.1 | DTPA | 0.5 | | | Reminder | 10.3 | A | A |
| | | | B | 0.03 | | | | | | | | | | | | | | |
| Example 19 | DBU | 0.2 | A | 0.05 | | | DMSO | 40.0 | | | | | | | Reminder | 10.0 | C | A |
| Example 20 | DBN | 0.9 | A | 0.01 | | | EGBE | 3.0 | 5M-BTA | 0.2 | | | H₃PO₄ | 0.2 | Reminder | 8.9 | A | B |
| Example 21 | DBU | 1.0 | A | 0.001 | | | DEGEE | 2.0 | | | DTPA | 0.1 | | | Reminder | 11.0 | B | A |
| Example 22 | DBU | 0.6 | A | 0.01 | | | EGBE | 3.0 | 5M-BTA | 0.2 | DTPA | 0.3 | | | Reminder | 9.3 | A | A |
| Example 23 | DBU | 0.7 | A | 0.01 | | | EGBE | 3.0 | 5M-BTA | 0.2 | DTPA | 0.3 | | | Reminder | 10.0 | A | A |
| Comparative Example 1 | DBU | 1.0 | | | | | | | | | NTMP | 1.0 | | | Reminder | 10.1 | D | B |

**[Table 2]**

| | Composition of treatment liquid | | | | | | | | | | | pH of treatment liquid | Evaluation | |
|---|---|---|---|---|---|---|---|---|---|---|---|---|---|---|
| | First component | | Second component | | Co film roughness | | Corrosion inhibitor | | Chelating agent | | Water | | Co film roughness | Particle defect suppressiveness |
| | Type | Content [% by mass] | Type | Content [% by mass] | Type | Content [% by mass] | Type | Content [% by mass] | Type | **Content** [% by mass] | | | | |
| Example 24 | DBU | 0.4 | B | 0.004 | EGBE | 3.0 | 5M-BTA | 0.2 | HIDA | 0.3 | Reminder | 9.0 | A | A |
| Example 25 | DBU | 0.2 | B | 0.002 | EGBE | 3.0 | 5M-BTA | 0.2 | HIDA | 0.1 | Reminder | 9.2 | A | A |
| Example 26 | DBU | 0.6 | B | 0.002 | EGBE | 3.0 | 5M-BTA | 0.2 | HIDA | 0.6 | Reminder | 9.0 | A | A |
| Example 27 | DBU | 0.8 | B | 0.002 | EGBE | 3.0 | 5M-BTA | 0.2 | HIDA | 0.9 | Reminder | 8.8 | A | A |
| Example 28 | DBU | 1.3 | B | 0.0 | EGBE | 3.0 | 5M-BTA | 0.2 | EDTMP | 0.1 | Reminder | 9.5 | A | A |
| Example 29 | DBU | 0.9 | B | 0.0 | EGBE | 3.0 | 5M-BTA | 0.2 | NTMP | 0.2 | Reminder | 9.0 | A | A |

From the results of Tables 1 and 2, it was found that the treatment liquid according to the embodiment of the present invention was excellent in the property of suppressing the surface roughness of the Co film.

From the comparison of Examples 1 to 5, it was found that, in a case where the treatment liquid contained a chelating agent, the particle defect suppressiveness was more excellent.

From the comparison of Examples 1 to 6 and 8, it was found that, in a case where the treatment liquid contained a corrosion inhibitor, the property of suppressing the surface roughness of the Co film was more excellent.

From the comparison of Examples 6, 7, and 19, it was found that, in a case where the content of the organic solvent was 20% by mass or less with respect to the total mass of the treatment liquid, the property of suppressing the surface roughness of the Co film was more excellent.

## Claims

1. A treatment liquid for a semiconductor device, the treatment liquid comprising:
water;
a first component which is an alicyclic heterocyclic compound containing a nitrogen atom as a ring member atom; and
a second component which is a compound different from the first component and is an alicyclic heterocyclic compound having a hydroxyl group.

2. The treatment liquid according to claim 1,
wherein the first component contains two or more nitrogen atoms as ring member atoms.

3. The treatment liquid according to claim 1,
wherein the first component includes at least one selected from the group consisting of 1,8-diazabicyclo[5.4.0]undec-7-ene and 1,5-diazabicyclo[4.3.0]non-5-ene.

4. The treatment liquid according to claim 1,
wherein the second component contains a nitrogen atom or an oxygen atom as a ring member atom.

5. The treatment liquid according to claim 1,
wherein the second component is a compound represented by Formula (1) or a compound represented by Formula (2), 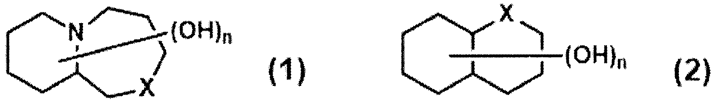
in Formula (1) and Formula (2), X's each independently represent an oxygen atom, an imino group, or an imino group having a substituent, and n represents an integer of 1 to 3.

6. The treatment liquid according to claim 1,
wherein a content of the water is 70% by mass or more with respect to a total mass of the treatment liquid.

7. The treatment liquid according to claim 1, further comprising:
a chelating agent having a carboxylic acid group or a chelating agent having a phosphonic acid group.

8. The treatment liquid according to claim 1, further comprising:
an organic solvent.

9. The treatment liquid according to claim 8,
wherein the organic solvent includes at least one selected from the group consisting of a glycol-based solvent, a glycol ether-based solvent, an amide-based solvent, an alcohol-based solvent, and a sulfoxide-based solvent.

10. The treatment liquid according to claim 1, further comprising:
a corrosion inhibitor.

11. The treatment liquid according to claim 10,
wherein the corrosion inhibitor includes at least one compound selected from the group consisting of a compound represented by Formula (A), a compound represented by Formula (B), a compound represented by Formula (C), and a substituted or unsubstituted tetrazole, 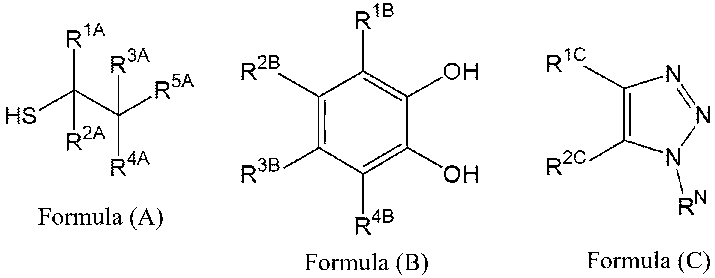
in Formula (A), R^{1A} to R^{5A} each independently represent a hydrogen atom, a substituted or unsubstituted hydrocarbon group, a hydroxyl group, a carboxy group, or a substituted or unsubstituted amino group, provided that at least one group selected from the hydroxyl group, the carboxy group, or the substituted or unsubstituted amino group is contained in a structure,
in Formula (B), R^{1B} to R^{4B} each independently represent a hydrogen atom or a substituted or unsubstituted hydrocarbon group,
in Formula (C), R^{1C}, R^{2C}, and R^{N} each independently represent a hydrogen atom or a substituted or unsubstituted hydrocarbon group, where R^{1C} and R^{2C} may be bonded to each other to form a ring.

12. The treatment liquid according to claim 1, further comprising:
at least one hydroxylamine compound selected from the group consisting of hydroxylamine, a derivative of hydroxylamine, and salts thereof.

13. The treatment liquid according to claim 1, further comprising:
an inorganic acid.

14. A method for treating an object to be treated, comprising:
a step of bringing an object to be treated having a cobalt-containing layer into contact with the treatment liquid according to any one of claims 1 to 13.
